(19) Europäisches Patentamt
European Patent Office
Office européen des brevets

(11) **EP 2 826 754 A1**

(12) **EUROPEAN PATENT APPLICATION**
published in accordance with Art. 153(4) EPC

(43) Date of publication:
**21.01.2015 Bulletin 2015/04**

(51) Int Cl.:
*C03B 19/02* (2006.01)        *G02B 5/18* (2006.01)
*H05B 33/02* (2006.01)        *H05B 33/10* (2006.01)

(21) Application number: 13760290.0

(22) Date of filing: **22.01.2013**

(86) International application number:
**PCT/JP2013/051202**

(87) International publication number:
**WO 2013/136844 (19.09.2013 Gazette 2013/38)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **16.03.2012   JP 2012060925**
**21.03.2012   JP 2012064140**

(71) Applicant: **JX Nippon Oil & Energy Corporation**
**Chiyoda-ku**
**Tokyo 100-8162 (JP)**

(72) Inventors:
• **TORIYAMA, Shigetaka**
**Tokyo 100-8162 (JP)**

• **NISHIMURA, Suzushi**
**Tokyo 100-8162 (JP)**
• **KOZASA, Naoto**
**Tokyo 100-8162 (JP)**
• **KUMAGAI, Yoshihiro**
**Tokyo 100-8162 (JP)**
• **TAKAHASHI, Madoka**
**Tokyo 100-8162 (JP)**

(74) Representative: **Kuhnen & Wacker**
**Patent- und Rechtsanwaltsbüro**
**Prinz-Ludwig-Straße 40A**
**85354 Freising (DE)**

(54) **MANUFACTURING METHOD AND MANUFACTURING DEVICE FOR OPTICAL SUBSTRATE HAVING CONCAVO-CONVEX PATTERN USING FILM-SHAPED MOLD, AND MANUFACTURING METHOD FOR DEVICE PROVIDED WITH OPTICAL SUBSTRATE**

(57)    A method for manufacturing an optical substrate includes: a step S0 for preparing a long film-shaped mold (80a); a step S1 for preparing a sol; a step S2 for forming a coating film (42) of the sol on a substrate; a step S3 for drying the coating film; a step S4 for pressing a pattern surface of the film-shaped mold against the dried coating film with a pressing roll (22) while feeding the film-shaped mold to the pressing roll; a step S5 for releasing the film-shaped mold from the coating film; and a step S6 for baking the coating film to which the concave and convex pattern has been transferred.

Fig. 4

EP 2 826 754 A1

## Description

### Technical Field

The present invention relates to a manufacturing method for manufacturing an optical substrate having a minute or fine concave and convex pattern (concavo-convex pattern) for scattering or diffracting light, by using a long film-shaped mold; an apparatus performing the manufacturing method; and a method for manufacturing a device provided with the optical substrate produced by the manufacturing method.

### Background Art

There has been known a lithography method as a method for forming a minute pattern such as a semiconductor integrated circuit. The resolution of the pattern formed by the lithography method is dependent on the wavelength of a light source and the numerical aperture of an optical system, and the light source is expected to have shorter wavelength in order to meet demand for miniaturized devices in recent years. However, the light source having the short wavelength is expensive, development thereof is not easy, and the development of an optical material transmitting such a short-wavelength light is also needed. Further, manufacturing a large-area pattern through a conventional lithography method needs a large-size optical element, and thus there are difficulties in technical and economic aspects. Therefore, a novel method for forming a desired pattern on a large area has been studied.

There has been known a nanoimprint method as a method for forming a minute pattern without using any conventional lithography apparatus. The nanoimprint method is a technique such that a pattern of an order of nanometer can be transferred by sandwiching a resin between a mold and a substrate. A thermal nanoimprint method, a photonanoimprint method, and the like have been studied depending on the employed material. Of the above methods, the photonanoimprint method includes four steps of: i) resin coating (application of a resin layer); ii) pressing by use of the mold; iii) photo-curing; and iv) mold-releasing. The photonanoimprint method is excellent in that processing on a nanoscale can be achieved by the simple process as described above. Especially, since a photo-curable resin curable by being irradiated with light is used as the resin layer, a period of time for a pattern transfer step is short and high throughput is promised. Thus, the photonanoimprint method is expected to come into practical use in many fields including, for example, an optical member such as an organic EL element (Organic Electro-Luminescence element or organic light emitting diode) and LED, MEMS, and a biochip, in addition to a semiconductor device.

For example, in the organic EL element (organic light emitting diode), a hole injected from a hole injecting layer and electron injected from an electron injecting layer are carried to a light emitting layer respectively, then the hole and electron are recombined on an organic molecule in the light emitting layer to excite the organic molecule, and thereby light emission occurs. Therefore, in a case that the organic EL element is used as a display device and/or an illumination device, the light from the light emitting layer is required to be efficiently extracted from the surface of the organic EL element. In order to meet this demand, PATENT LITERATURE 1 discloses that a diffraction-grating substrate is provided on a light extraction surface of the organic EL element.

### Citation List

### Patent Literature

PATENT LITERATURE 1: Japanese Patent Application Laid-open No. 2006-236748
PATENT LITERATURE 2: PCT International Publication No. WO2011/007878A1

The applicant of the present invention discloses the following method in PATENT LITERATURE 2 in order to manufacture a concave and convex pattern of the diffraction grating substrate for the organic EL element. That is, a solution obtained by dissolving a block copolymer satisfying a predetermined condition into a solvent is applied on a base member to form a micro phase separation structure of the block copolymer by using a self-organizing phenomenon of the block copolymer, and thereby obtaining a master block (metal substrate) in which a minute or fine and irregular concave and convex pattern is formed. A mixture of a silicon-based polymer and a curing agent is dripped onto the obtained master block and then cured to obtain a transferred pattern as a mold. Then, a glass substrate coated with a curable resin is pressed against the transferred pattern and the curable resin is cured by irradiation with ultraviolet rays. In this way, a diffraction grating in which the transferred pattern is duplicated is manufactured. The organic EL element can be obtained by stacking a transparent electrode, an organic layer, and a metal electrode on the diffraction grating.

However, in order to mass-produce the above-mentioned diffraction grating for the organic EL element, it is necessary to efficiently perform the pattern transfer (pattern formation) onto the material such as the curable resin by using the transferred pattern a of the mold.

Thus, it is expected to develop a new transfer process and transfer apparatus which are capable of mass-producing the optical substrate, such as the diffraction-grating substrate, used for the organic EL element and the like with high throughput by using the nanoimprint method.

The photo-curable resin described above generally has low heat resistance, and is decomposed and/or turns into yellow at high temperature. Thus, there is fear that a film having the minute pattern might be broken in a case that a high-temperature treatment is included in subsequent steps. Further, the photo-curable resin has a low adhesion property to a glass substrate. Furthermore, in a case that the resin layer to which the pattern has been transferred is used for an element such as the organic EL element, there is fear that impurities are eluted from the resin layer to cause adverse effect on the element. Therefore, in order to mass-produce the optical substrate, such as the diffracting-grating substrate, for the organic EL element with high throughput by using the nanoimprint method, the material for forming the concave and convex pattern on the glass substrate and/or mold material are required to be optimized.

## Summary of Invention

### Technical Problem

In view of the above, an object of the present invention is to provide a novel manufacturing method and manufacturing apparatus capable of mass-producing an optical substrate and a device provided with the optical substrate with high throughput, the optical substrate including a minute or fine concave and convex pattern which has a high adhesion property to a substrate, heat resistance, and weather resistance.

### Solution to the Problem

According to a first aspect of the present invention, there is provided a method for manufacturing an optical substrate having a concave and convex pattern, including:

a step of preparing a long film-shaped mold having a surface of the concave and convex pattern;
a step of forming a coating film made of a sol-gel material on a substrate;
a step of transferring the surface of the concave and convex pattern of the film-shaped mold to the coating film by arranging the surface of the concave and convex pattern to face the coating film and pressing a pressing roll against a surface of the film-shaped mold on a side opposite to the surface of the concave and convex pattern;
a step of releasing the film-shaped mold from the coating film; and
a step of curing the coating film to which the concave and convex pattern has been transferred.

In the method for manufacturing the optical substrate, the step of curing the coating film may include curing the coating film by baking the coating film.

In the method for manufacturing the optical substrate, the step of preparing the long film-shaped mold may include:

coating a long film-shaped base member with a concave-convex forming material;
performing a roll transfer of the concave and convex pattern to the concave-convex forming material by pressing a transfer roll having the concave and convex pattern against the concave-convex forming material coating the long film-shaped base member while rotating the transfer roll; and
curing the concave-convex forming material to which the concave and convex pattern has been transferred through the roll transfer so as to obtain the long film-shaped mold in a roll shape. Further, the film-shaped base member having the cured concave-convex forming material may be wound around a film winding roll, and/or the concave and convex pattern of the transfer roll may be transferred while the film-shaped base member is transported by using a film feeding roll feeding the film-shaped base member and the film winding roll winding or rolling up the film-shaped base member. In any case, the long film-shaped mold in the roll shape wound around the film winding roll may move with being fed to the pressing roll. The released long film-shaped mold may be wound around a mold winding roll.

In the method for manufacturing the optical substrate, the pressing roll may be pressed against the surface of the film-shaped mold on the side opposite to the surface of the concave and convex pattern while the concave-convex forming material being heated. By doing so, the pre-baking of the sol-gel material is performed simultaneously with the pressing, which makes it possible to form the concave and convex pattern reliably and to facilitate the releasing of the surface of the concave and convex pattern from the coating film after the pressing. Further, it is possible to further facilitate the releasing of the surface of the concave and convex pattern from the coating film after the pressing by heating the pressed concave-convex forming material in the releasing step or between the transfer step and the releasing step.

In the method for manufacturing the optical substrate, the surface of the concave and convex pattern of the long film-shaped mold may be successively pressed against coating films on a plurality of substrates with the pressing roll while continuously feeding the long film-shaped mold under or below the pressing roll and transporting each of the substrates to the pressing roll at a predetermined time interval with the coating film made of the sol-gel material being formed. The use of the long film-shaped mold enables the continuous process of each of the substrates, thereby making it possible to improve the throughput of manufacture of the optical substrate. The length of the film-shaped mold can be adjusted to a length enough to produce the optical substrate in amount of one lot, for example, hundreds to thousands of optical substrates. For example, the length of the film-shaped mold can be adjusted in a range of several hundreds of meters to several thousands of meters.

The concave and convex pattern of the film-shaped mold used in the method for manufacturing the optical substrate may be, for example, an irregular concave and convex pattern in which an average pitch of concavities and convexities is in a range of 100 to 1500 nm and an average value (average height) of a depth distribution of the concavities and convexities is in a range of 20 to 200 nm.

According to a second aspect of the present invention, there is provided an apparatus for manufacturing an optical substrate, including:

a coating-film forming section configured to form a coating film made of a sol-gel material on a substrate;

a substrate transporting section configured to transport the substrate on which the coating film is formed to a predetermined position;

a mold transporting section which includes a mold feeding roll configured to feed a long film-shaped mold having a surface of a concave and convex pattern and a mold winding roll configured to wind or roll up the long film-shaped mold, and is configured to transport the film-shaped mold to the predetermined position by continuously feeding the film-shaped mold from the mold feeling roll to the predetermined position and winding the film-shaped mold around the mold wining roll; and

a pressing roll rotatably arranged at the predetermined position and configured to press a part of the surface of the concave and convex pattern of the long film-shaped mold, which is fed to the predetermined position by the mold transporting section, against the coating film on the substrate which is transported to the predetermined position by the substrate transporting section.

The apparatus for manufacturing the optical substrate may further include a peeling roll configured to peel (release) the part of the surface of the concave and convex pattern of the long film-shaped mold pressed with the pressing roll from the coating film on the substrate.

The apparatus for manufacturing the optical substrate may further include a heating means configured to heat the coating film on the substrate against which the part of the surface of the concave and convex pattern of the film-shaped mold is pressed. The heating means may be provided in the pressing roll. The apparatus for manufacturing the optical substrate may further include a heating means configured to heat the coating film when the film-shaped mold is released (peeled off) from the coating film.

The apparatus for manufacturing the optical substrate may further include a supporting roll provided at a position to face the pressing roll and configured to support the substrate from a lower side of the substrate. The coating-film forming section may include a substrate stage configured to move the substrate while holding the substrate.

The concave and convex pattern of the film-shaped mold used in the apparatus for manufacturing the optical substrate may be, for example, an irregular concave and convex pattern used for scattering or diffracting light in which an average pitch of concavities and convexities is in a range of 100 to 1500 nm and an average value (average height) of a depth distribution of the concavities and convexities is in a range of 20 to 200 nm.

The apparatus for manufacturing the optical substrate may further include a roll process apparatus configured to form the long film-shaped mold, the roll process apparatus including: a transporting system configured to transport a substrate film; a coating unit configured to coat the substrate film being transported with a concave-convex forming material; a transfer roll provided on a downstream side of the coating unit and configured to transfer the concave and convex pattern to the concave-convex forming material; and a radiation light source configured to emit light to the substrate film. The transporting system may include a film feeding roll configured to feed the substrate film; a nip roll configured to urge the substrate film toward the transfer roll; a releasing roll configured to facilitate releasing of the substrate film from the transfer roll; and a film winding roll configured to wind or roll up the substrate film to which the concave and convex pattern has been transferred. In this case, the film winding roll around which the substrate film is wound may be used as the mold feeding roll configured to feed the film-shaped mold.

According to a third aspect of the present invention, there is provided a method for manufacturing a device provided with an optical substrate having a concave and convex pattern, including:

a substrate formation step of forming a substrate with a predetermined concave and convex pattern by coating the substrate with a sol-gel material and transferring the concave and convex pattern to the sol-gel material coating the substrate;
a cleaning step of cleaning the substrate with the concave and convex pattern;
a first electrode formation step of forming a first electrode on the cleaned substrate by patterning;
an annealing step of annealing the substrate in which the first electrode is formed;
a thin film formation step of forming a thin film on the first electrode; and
a second electrode formation step of forming a second electrode on the thin film.

In the method for manufacturing the device of the present invention, the so-gel material as a transfer-target material of the concave and convex pattern has corrosion resistance and high strength as compared with resin material. Thus, ultrasonic cleaning, cleaning with a brush, and/or UV/$O_3$ cleaning may be performed in the cleaning step.

In the method for manufacturing the device of the present invention, the patterning may be performed by using an acid solvent or an alkaline solvent, and the patterning may include formation of a first electrode layer, resist coating (application of a resist), exposure and development, etching of the first electrode layer, and stripping (removing) of the resist. The sol-gel material also has the corrosion resistance to the solvent used for each of the processes.

In the method for manufacturing the device of the present invention, since the sol-gel material as the transfer-target material of the concave and convex pattern has heat resistance, the annealing may be performed at a temperature in a range of 160 degrees Celsius to 360 degrees Celsius.

The method for manufacturing the device of the present invention is suitable for the manufacture of an organic EL element as the device. In this case, the first electrode may be a transparent electrode, the thin film may include an organic layer, and the second electrode may be a metal electrode. Further, the method for manufacturing the device of the present invention is suitable for the manufacture of a solar cell as the device. In this case, the first electrode may be a transparent electrode, the thin film may include a semiconductor layer, and the second electrode may be a metal electrode.

The concave and convex pattern used in the method for manufacturing the device of the present invention may be an irregular concave and convex pattern used for scattering or diffracting light in which an average pitch of concavities and convexities is in a range of 100 to 1500 nm and an average value of a depth distribution of the concavities and convexities is in a range of 20 to 200 nm. The substrate may be a glass substrate and the sol-gel material may include a silica precursor. The method for manufacturing the device of the present invention may further include baking of the sol-gel material at a temperature of 300 degrees Celsius or more after coating the substrate with the sol-gel material and transferring the predetermined concave and convex pattern to the so-gel material coating the substrate.

In the method for manufacturing the device of the present invention, the substrate formation step may include:

a step of preparing a long film-shaped mold having a surface of the concave and convex pattern;
a step of forming a coating film made of the sol-gel material on the substrate;
a step of transferring the surface of the concave and convex pattern of the film-shaped mold to the coating film by arranging the surface of the concave and convex pattern of the film-shaped mold to face the coating film and pressing a pressing roll against a surface of the film-shaped mold on a side opposite to the surface of the concave and convex pattern;
a step of releasing (peeling) the film-shaped mold from the coating film; and
a step of baking the coating film to which the concave and convex pattern has been transferred.

**Advantageous Effects of Invention**

In the method for manufacturing the optical substrate of the present invention, since the sol-gel material is used as the concave-convex pattern forming material and the roll process with the long film-shaped mold is utilized to form the concave and convex pattern made of the sol-gel material, it is possible to manufacture the optical substrate with high throughput while performing the pattern transfer accurately and reliably. Since the concave and convex pattern of the optical substrate manufactured by the method for manufacturing the optical substrate of the present invention is made of the sol-gel material, the optical substrate with the concave and convex pattern is excellent in heat resistance, weather resistance (of which concept includes light resistance), and corrosion resistance. Further, the optical substrate with the concave and convex pattern is also resistant to the manufacturing process of an element in which the optical substrate is incorporated, which makes it possible to extend the service life of the element.

Since the long film-shaped mold is utilized in the present invention, there are advantages as follows. That is, regarding a hard mold made of metal, silica, and the like, in a case that any defect has been found in a concave and convex pattern of the hard mold, it is possible to clean and/or repair the defect. Thus, any failure can be avoided which would be otherwise caused by the transfer of the defect to the so-gel material layer. However, in the film-shaped mold, the cleaning and the repair as described above are less likely to be performed easily. In the meanwhile, the mold made of metal, silica, and the like is in a roll shape, and when any defect such as clogging occurs in the mold, a transfer device is required to be immediately stopped to exchange the mold. However, since the transfer using the film-shaped mold is performed while each of the parts of the film-shaped mold being made to correspond to each single glass substrate, a part having the defect such as the clogging is marked at an inspection stage, and the transport of the glass substrate can be suspended until the defect part passes through the glass substrate. Therefore, on the whole, the use of the film-shaped mold can reduce the occurrence of defective product and thereby making it possible to improve the throughput.

In a case that the concave and convex pattern of the hard mold made of metal, silica, and the like is tried to be directly transferred to the sol-gel material layer, various limitations as described below arise and thereby a desired performance can not be given sufficiently in some cases. For example, in a case that a hard substrate such as glass is used as the substrate on which the sol-gel material layer is formed, the adjustment of the pressure applied to the mold is difficult. For example, if the pressure applied to the mold is high, the substrate is damaged, for example, to have a crack since both of the substrate and the mold are hard; or if the pressure applied to the mold is low, the concave and convex pattern is transferred insufficiently. Therefore, a soft material must be used for the substrate or the mold. Even when the film-shaped mold (soft mold) is used, a material to which the concave and convex pattern is transferred is required to have a superior mold-releasing property, a superior adhesion property to the substrate, and a superior transferability of the concave and convex pattern. Thus, the material must be selected from among limited materials. Accordingly, by dividing the method for manufacturing the optical substrate into two steps including the first step of manufacturing the film-shaped mold from the metal mold and the second step of performing the transfer to the sol-gel material layer with the film-shaped mold, and by selecting a material suitable for each of the steps, a desired material can be used on a desired substrate in the optical substrate. Consequently, the transfer can be performed to have a satisfactory mold-releasing property without causing any pattern defect, while satisfying necessary characteristics.

In the method for manufacturing the device of the present invention, since the concave and convex pattern of the optical substrate is made of the sol-gel material, the optical substrate has the resistance to the cleaning with the brush and the UV/$O_3$ cleaning in the cleaning step of cleaning the substrate with the concave and convex pattern, the corrosion resistance to the acid solvent or alkali solvent used in the first electrode formation step, and the heat resistance to high temperature in the subsequent annealing step. Therefore, it is possible to produce the device without inhibiting optical characteristics of the optical substrate with the concave and convex pattern and/or an adhesion property to the thin film, which is formed as a working layer, on the optical substrate. Further, the method for manufacturing the device of the present invention also contributes to improve the heat resistance, the weather resistance, and the corrosion resistance of the device itself manufactured by the method for manufacturing the device of the present invention. Accordingly, the method for manufacturing the device of the present invention is extremely useful when manufacturing various devices such as the organic EL element and the solar cell with high throughput.

**Brief Description of Drawings**

Fig. 1 is a flowchart showing a method for manufacturing a device of the present invention.
Fig. 2 is a flowchart showing manufacturing steps of an optical substrate used for the method for manufacturing the device of the present invention.
Fig. 3 is a conceptual view of a roll process apparatus for manufacturing a film-shaped mold used for manufacture of the optical substrate.
Fig. 4 is a conceptual view for illustrating a roll process using the film-shaped mold.
Figs. 5(a) to 5(f) conceptually show a process for manufacturing an ITO transparent electrode.
Fig. 6 shows a cross-section structure of an organic EL element.
Fig. 7 is a conceptual view of an optical substrate manufacturing apparatus for performing a method for manufacturing the optical substrate of the present invention.
Fig. 8 is a conceptual view illustrating a modified embodiment of the optical substrate manufacturing apparatus, in which no peeling roll is utilized.
Fig. 9 is a conceptual view illustrating another modified embodiment of the optical substrate manufacturing apparatus, in which the film-shaped mold as an endless belt is utilized.
Fig. 10 is a conceptual view illustrating still another modified embodiment of the optical substrate manufacturing apparatus, in which a heat zone as a heating means of a sol-gel material layer is provided in a pressing section.
Fig. 11 is a conceptual view illustrating an apparatus for inspecting unevenness of a diffraction grating substrate.
Fig. 12(a) is a photograph showing an image from the surface of the substrate observed in Example 1, and Fig.

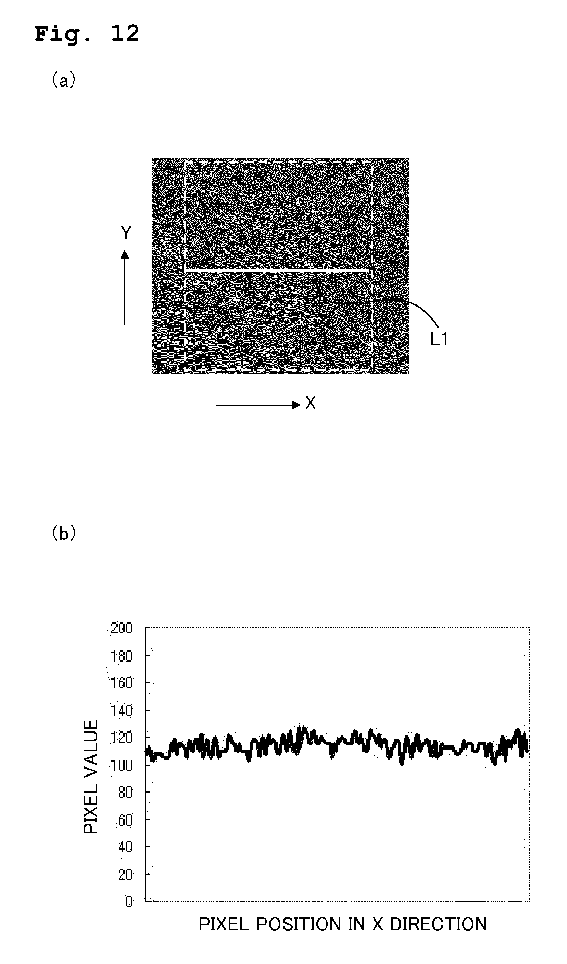

12(b) is a graph showing profile of pixel positions on the line L1 in the photograph of Fig. 12(a) and pixel values at the pixel positions.

**Description of Embodiments**

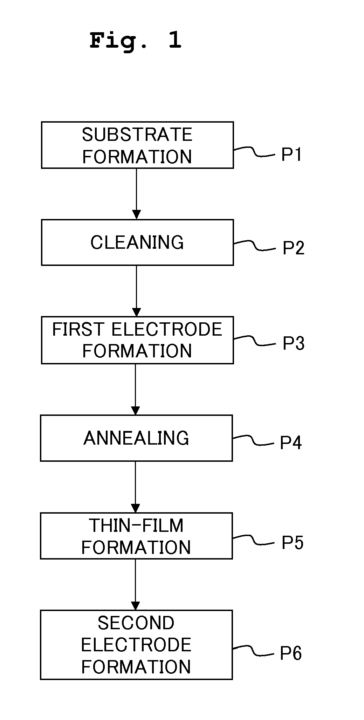

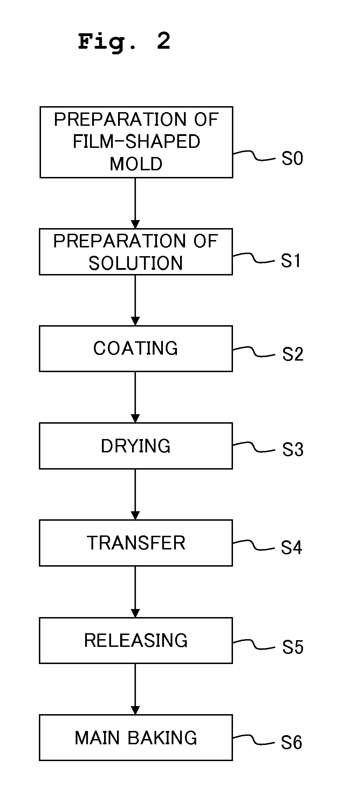

In the following, embodiments of the present invention will be described with reference to the drawings. As shown in Fig. 1, a method for manufacturing a device provided with an optical substrate having a concave and convex pattern according to the present invention mainly includes: a substrate formation step P1 for forming a substrate in which the concave and convex pattern is formed; a cleaning step P2 for cleaning the substrate in which the concave and convex pattern is formed; a first electrode formation step P3 for forming a first electrode on the cleaned substrate by patterning using an acid solvent or alkaline solvent; an annealing step P4 for annealing the substrate, on which the patterned first electrode is formed, at a predetermined temperature; a thin film formation step P5 for forming a thin film on the annealed substrate; and a second electrode formation step S6 for forming a second electrode on the thin film. The substrate formation step P1 for forming the substrate in which the concave and convex pattern is formed includes a method for manufacturing the optical substrate having the concave and convex pattern according to the present invention. As shown in Fig. 2, the method for manufacturing the optical substrate having the concave and convex pattern mainly includes a step S0 for preparing a film-shaped mold; a solution preparation step S1 for preparing a sol-gel material; a coating step S2 for coating a substrate with the prepared sol-gel material (applying the prepared sol-gel material on a substrate); a drying step S3 for drying the coating film of the sol-gel material coating the substrate; a transfer step S4 for pressing the film-shaped mold in which a transfer pattern is formed against the dried coating film with a pressing roll; a releasing step (peeling step) S5 for releasing (peeling off) the mold from the coating film; and a main baking step S6 in which the coating film is subjected to main baking.

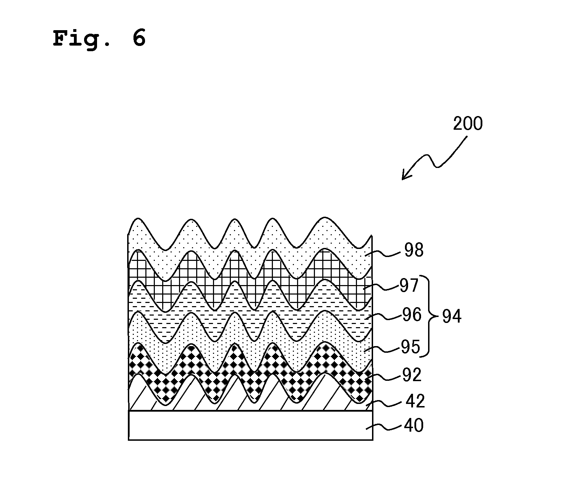

Hereinbelow, the method for manufacturing the optical substrate and the method for manufacturing the device including the optical substrate manufactured by this manufacturing method according to the present invention will be explained by citing a manufacturing process of an organic EL element 200 as shown in Fig. 6, as an example, the organic EL element 200 including a stacked structure on a substrate (diffraction grating substrate) 40 having a sol-gel material layer 42 in which a concave and convex pattern is formed.

[Substrate formation step]

At first, an explanation will be made about a method for manufacturing the substrate 40 including the sol-gel material layer 42 in which the concave and convex pattern is formed using the method for manufacturing the optical substrate of the present invention by citing, as an example.

<Step for preparing film-shaped mold>

The film-shaped mold used for manufacturing an optical member of the present invention is a film-shaped or sheet-shaped mold which is long, flexible, and has a concave and convex transfer pattern on a surface thereof. The mold is made, for example, of organic materials such as silicone resin, polyethylene terephthalate (PET), polyethylene naphthalate (PEN), polycarbonate (PC), cycloolefin polymer (COP), polymethyl methacrylate (PMMA), polystyrene (PS), polyimide (PI), and polyarylate. The concave and convex pattern may be formed directly in each of the materials, or may be formed in (on) a concave-convex forming material with which a base material (substrate sheet) formed of the above-mentioned materials is coated. It is possible to use photo-curable resin, thermosetting resin, and thermoplastic resin as the concave-convex forming material.

The film-shaped mold is, for example, a long mold which may have 10 meter or more in length, 50 to 3000 mm in width, and 1 to 500 $\mu$m in thickness. The size of the film-shape mold, in particular, the length thereof can be set appropriately based on the size of the optical substrate to be mass-produced, the number of optical substrates (the number of lots) continuously produced in a single manufacturing process. A surface treatment or an easy-adhesion treatment may be performed to improve an adhesion property between the substrate and the coating material (concave-convex forming material). Further, a mold-release treatment may be performed on each surface of the concave and convex pattern as needed. The concave and convex pattern may be formed to have any profile by arbitrary method.

The concave and convex pattern of the film-shaped mold varies in uses of the optical substrate finally obtained. The concave and convex pattern, for example, may be an irregular concave and convex pattern in which pitches of concavities and convexities are ununiform and orientations of the concavities and convexities have no directivity. In a case that the optical substrate is used for scattering or diffracting visible light, for example, the average pitch of the concavities and convexities can be within a range from 100 to 1500 nm, and is more preferably within a range from 200 to 1500 nm. In a case that the average pitch of the concavities and convexities is less than the lower limit, the pitches are so small relative to wavelengths of the visible light that the diffraction of light by the concavities and convexities is likely to be insufficient. In a case that the average pitch exceeds the upper limit, a diffraction angle is so small that functions as an optical element such as the diffracting grating are more likely to be lost. In similar uses, the average value (average height) of a depth distribution of the concavities and convexities is preferably in a range of 20 to 200 nm, and more preferably in a range of 50 to 150 nm.

The light scattered and/or diffracted by such a concave and convex pattern is not light having single wavelength or wavelength having a narrow band. The light scattered and/or diffracted by such a concave and convex pattern has a range of wavelength relatively broad, has no directivity, and is directed in various directions. However, the "irregular concave and convex pattern" includes a quasi-periodic structure such as that in which a Fourier-transformed image, which is obtained by performing a two-dimensional fast Fourier-transform processing on a concavity and convexity analysis image obtained by analyzing a concave and convex shape on the surface, shows a circular or annular pattern, that is, such as that in which, although the concavities and convexities have no particular orientation, the pitches of the concavities and convexities vary. Therefore, the substrate having such a quasi-periodic structure is suitable for a diffraction substrate used in a surface-emitting element and the like such as the organic EL element; a transparent conductive substrate of a solar cell; and the like, provided that the substrate has the concavities and convexities of which pitch distribution or pitch variability enables the substrate diffract visible light.

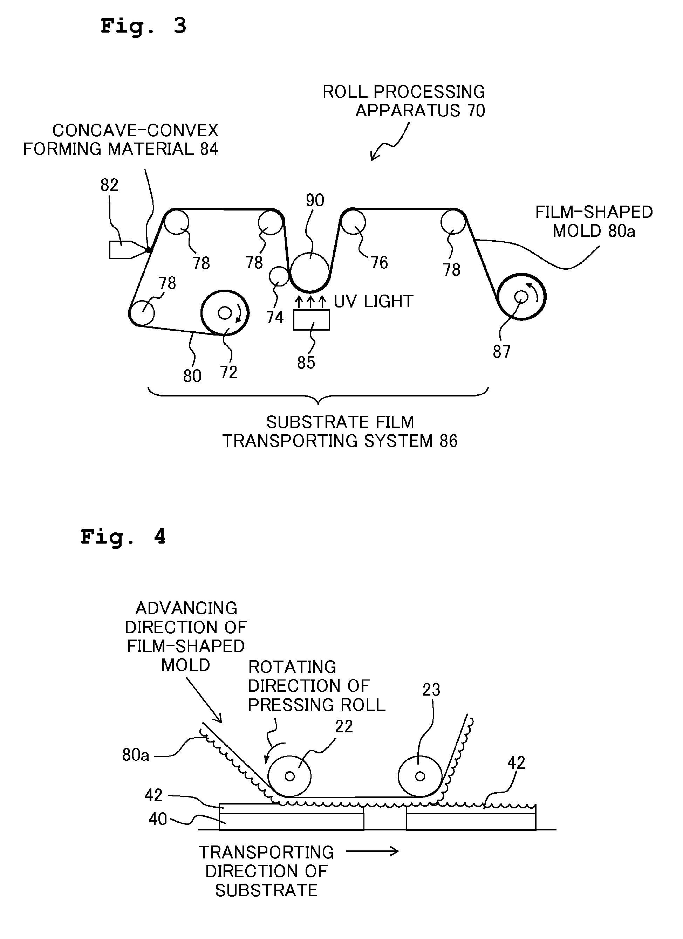

An exemplary method for manufacturing the long film-shaped mold used in the present invention will be explained by referring to Fig. 3. A roll process apparatus (first unit) 70 shown in Fig. 3 is an apparatus for manufacturing the film-shaped mold by forming a concave and convex pattern on a coating film formed on a long substrate film. The roll process apparatus 70 mainly includes a transporting system 86 which transports a substrate film (base material) 80, a die coater 82 which coats the substrate film 80 being transported with the material for forming the concavities and convexities, a transfer roll (metal mold) 90 which is positioned on the downstream side of the die coater 82 and transfers a pattern, and a radiation light source 85 which is provided to face the transfer roll 90 with the substrate film 80 intervening therebetween and emits UV light to the substrate film 80. The transporting system 86 for transporting the substrate film 80 includes a film feeding roll 72 which feeds the substrate film 80, a nip roll 74 which is arranged to face the transfer roll 90 with the substrate film 80 intervening therebetween, a releasing roll (peeling roll) 76 which facilitates the releasing (peeling) of the substrate film 80 from the transfer roll 90, a film winding roll 87 which winds or rolls up a substrate film 80a (film-shaped mold) having the pattern transferred thereon, and a plurality of transporting rolls 78 which transport the substrate film 80 while maintaining the tension of the substrate film 80.

The film-shaped mold is manufactured through the following manufacturing process by using the roll process apparatus 70. The substrate film 80 wound on the film feeding roll 72 in advance is fed to the downstream side by the rotations of the film feeding roll 72, the film winding roll 87, etc. When the substrate film 80 passes through the die coater 82, a concave-convex forming material 84 is applied on a surface of the substrate film 80 by the die coater 82 to form a coating film having a predetermined thickness. Then, the coating film on the substrate film 80 is pressed against the outer circumferential surface of the transfer roll 90 by the nip roll 74 so as to transfer a pattern of the outer circumferential surface of the transfer roll 90 to the coating film. At the same time or immediately after the above, UV light is emitted from the radiation light source 85 to the coating film so as to cure the concave-convex forming material 84. Although the wavelength of the UV light varies according to the concave-convex forming material 84, the wavelength of the UV light is generally in a range of 200 to 450 nm. The amount of irradiation may be in a range of 10 mJ/cm$^2$ to 5 J/cm$^2$. After releasing (peeling off) the substrate film 80 with the concave-convex forming material having the cured pattern from the transfer roll 90 by using the releasing roll (peeling roll) 76, the substrate film 80 is wound around the film winding roll 87. Accordingly, a long film-shaped mold 80a is obtained. Since the long film-shaped mold 80a is obtained in a roll shape, it is suitable for a mass-producing process of the optical substrate using a pressing roll which will be described later. Further, the shape of the long film-shaped mold 80a is suitable to be transported to an apparatus performing the mass-producing process of the optical substrate by use of the pressing roll. Additionally, since the film-shaped mold is rolled up it in a roll shape after being manufactured, storage and aging processes can be easily performed.

In the manufacturing process described above, the substrate film 80 is exemplified, for example, by base members made of inorganic materials such as glass; and
base members made of organic materials such as silicone resin, polyethylene terephthalate (PET), polyethylene naphthalate (PEN), polycarbonate (PC), cycloolefin polymer (COP), polymethyl methacrylate (PMMA), polystyrene (PS), polyimide (PI), and polyarylate. The thickness of the substrate film may be, for example, in a range of 1 to 500 $\mu$m.

The concave-convex forming material 84 is exemplified by curable resins such as various kinds of UV curable resins including, for example, epoxy resin, acrylic resin, methacrylic resin, vinyl ether resin, oxetane resin, urethane resin, melamine resin, urea resin, polyester resin, phenol resin, cross-linking type liquid crystal resin, fluorine resin, and silicone resin. The thickness of the curable resin is preferably in a range of 0.5 to 500 $\mu$m. In a case that the thickness is less than the lower limit, heights of the concavities and convexities formed on the surface of a cured resin layer are likely to be insufficient. In a case that the thickness exceeds the upper limit, the influence of volume change of the resin upon curing is likely to be so large that the formation of the shape of the concavities and convexities is liable to be unsatisfactory.

In the above manufacturing process, a die coating method by the die coater is used to coat the substrate film 80 with the concave-convex forming material 84 (apply the concave-convex forming material 84 on the substrate film 80). Instead of this, it is possible to adopt various coating methods such as a spin coating method, a spray coating method, a dip coating method, a dropping method, a gravure printing method, a screen printing method, a relief printing method, a curtain coating method, an ink-jet method, and a sputtering method. The condition for curing the concave-convex forming material 84 such as the curable resin varies depending on the kind of the resin used. For example, a curing temperature is preferably within a range from room temperature to 250 degrees Celsius, and an UV light irradiation amount is preferably within a range from 10 mJ/cm$^2$ to 5 J/cm$^2$. The concave-convex forming material 84 may be cured by irradiation with energy rays such as electron beams other than the UV light.

The transfer roll 90 used in the above-mentioned manufacturing process may be, for example, a roll having a pattern directly formed on a surface thereof such as a metal roll; a roll in which a substrate having a pattern such as a metal substrate is wound on the roll and then fixed thereto; or a roll formed by manufacturing a cylindrical substrate having a pattern and fitting and fixing it to the roll. The transfer roll 90 may be made of a hard material other than the metal.

Here, an explanation will be made about a method for forming a concave and convex pattern provided on the surface of the transfer roll 90. It is preferred that the concave and convex pattern be formed by a method of utilizing self-organization or assembly (micro phase separation) of a block copolymer described in Japanese Patent Application Laid-open No. 2011-006487 of the applicants of the present invention (hereinafter referred to as "BCP (Block Copolymer) method" as appropriate), a method of heating and cooling a polymer film on a vapor-deposited film to form concavities and convexities of wrinkles on a surface of polymer disclosed in PCT International Publication No. WO2011/007878A1 of the applicants of the present invention (hereinafter referred to as "BKL (Buckling) method" as appropriate), or the like. A photolithography method may be utilized instead of the BCP and BKL methods. In a case that the pattern is formed by the BCP method, the pattern can be made of any material, and the material is preferably a block copolymer composed of combinations of two selected from the group consisting of a styrene-based polymer such as polystyren; polyalkyl methacrylate such as polymethyl methacrylate; polyethylene oxide; polybutadiene; polyisoprene; polyvinylpyridine; and polylactic acid.

Pitches and heights of concavities and convexities of the pattern are arbitrary. For example, in a case that the pattern is used as the diffraction grating scattering or diffracting light in a visible region, the average pitch of the concavities and convexities is preferably in a range of 100 nm to 1500 nm, more preferably in a range of 200 nm to 1500 nm. In a case that the average pitch of the concavities and convexities is less than the lower limit, the pitches are so small relative to wavelengths of the visible light that the diffraction of the light by the concavities and convexities is less likely to occur. In a case that the average pitch exceeds the upper limit, a diffraction angle is so small that functions as an optical element such as the diffraction grating are more likely to be lost. The average value of the depth distribution of the concavities and convexities is preferably in a range of 20 nm to 200 nm, and more preferably in a range of 50 nm to 150 nm. In a case that the average value of the depth distribution of the concavities and convexities is less than the lower limit, the height is so short relative to the wavelengths of the visible light that the required diffraction is less likely to occur. In a case that the average value exceeds the upper limit, the intensity of diffracted light becomes non-uniform, and as a result, the following tendency is found. When the concave and convex pattern is used, for example, as the optical element for light extraction of the organic EL element, the electric field distribution in an EL layer becomes non-uniform, and electric fields concentrate on a certain position or area, thereby a leak current is more likely to arise and/or the service life of the optical element is shortened.

After forming the master block with the pattern by the BCP or BKL method, a mold to which the pattern is transferred can be formed by an electroforming method or the like, as follows. At first, a seed layer functioning as an electroconductive layer for an electroforming process can be formed on the master block, which has the pattern to be transferred, formed by non-electrolytic plating, sputtering, vapor deposition, or the like. The thickness of the seed layer is preferably not less than 10 nm to uniformize a current density during the subsequent electroforming process, and thereby making the thickness of a metal layer accumulated by the subsequent electroforming process uniform. As the material of the seed layer, it is possible to use, for example, nickel, copper, gold, silver, platinum, titanium, cobalt, tin, zinc, chrome, gold-cobalt alloy, gold-nickel alloy, boron-nickel alloy, solder, copper-nickel-chromium alloy, tin-nickel alloy, nickel-palladium alloy, nickel-cobalt-phosphorus alloy, or alloy thereof. Subsequently, a metal layer is accumulated on the seed layer by the electroforming (electroplating). The entire thickness of the metal layer including the thickness of the seed layer can be, for example, in a range of 10 to 3000 $\mu$m. As the material of the metal layer accumulated by the electroforming, it is possible to use any of metal species as described above which can be used as the seed layer. It is preferable to use nickel as the material of the metal layer in view of the wear resistance, the releasing property, and the like of a metal substrate to be obtained as the mold. In this case, nickel is preferably used also for the seed layer. Considering ease of the subsequent processes for forming the mold such as pressing to the resin layer, releasing, and cleaning, the formed metal layer desirably has appropriate hardness and thickness.

The metal layer including the seed layer obtained as described above is released (peeled off) from the master block having the concave and convex structure to obtain a metal substrate. In order to release the metal layer easily and reliably, it is preferred that an annealing process be performed by heating the master block with the pattern before the electroforming. As the releasing method, the metal layer may be peeled off physically, or the materials composing the pattern of the master block may be dissolved to be removed by using an organic solvent dissolving them, such as toluene, tetrahydrofuran (THF), and chloroform. In a case that the metal substrate is peeled off from the master block, a remaining material component on the metal substrate can be removed by cleaning. As the cleaning method, it is possible to use wet cleaning using a surfactant etc., or dry cleaning using ultraviolet rays and/or plasma. Alternatively, for example, the remaining material component may be attached to an adhesive agent or a bonding agent then be removed. Accordingly, the metal substrate to which the pattern has been transferred from the master block can be obtained. The transfer roll 90 having the concave and convex pattern can be obtained by winding or putting the metal substrate obtained as described above around the surface of a roll body. It is possible to form the film-shaped mold by using the transfer roll 90 by the above manufacturing process. It is needless to say that the long film-shaped mold is not required to be self-manufactured and a long film-shaped mold manufactured by a manufacturer such as a film manufacturer may be used. The step for preparing the film-shaped mold may be performed at any time, provided that the step is performed before the transfer step S4 which will be described later. Thus, it is not indispensable to perform the step for preparing the film-shaped mold before the sol-gel material preparation step S1.

<Sol-gel material preparation step>

In the method for manufacturing the optical substrate of the present invention, the sol-gel material is prepared to form the coating film to which the pattern is transferred by a sol-gel method (step S1 of Fig. 2). For example, in a case that silica is synthesized on a substrate by the sol-gel method, a sol-gel material of metal alkoxide (silica precursor) is prepared. The silica precursor is exemplified by metal alkoxides including, for example, tetraalkoxide monomers such as tetramethoxysilane (TMOS), tetraethoxysilane (TEOS), tetra-i-propoxysilane, tetra-n-propoxysilane, tetra-i-butoxysilane, tetra-n-butoxysilane, tetra-sec-butoxysilane, and tetra-t-butoxysilane; trialkoxide monomers such as methyl trimethoxysilane, ethyl trimethoxysilane, propyl trimethoxysilane, isopropyl trimethoxysilane, phenyl trimethoxysilane, methyl triethoxysilane (MTES), ethyl triethoxysilane, propyl triethoxysilane, isopropyl triethoxysilane, phenyl triethoxysilane, methyl tripropoxysilane, ethyl tripropoxysilane, propyl tripropoxysilane, isopropyl tripropoxysilane, phenyl tripropoxysilane, methyl triisopropoxysilane, ethyl triisopropoxysilane, propyl triisopropoxysilane, isopropyl triisopropoxysilane, phenyl triisopropoxysilane; a polymer obtained by polymerizing the above monomers in small amounts; and a composite material characterized in that functional group and/or polymer is/are introduced into a part of the above material. Further, the silica precursor is exemplified, for example, by metal acetylacetonate, metal carboxylate, oxychloride, chloride, and mixtures thereof. The silica precursor, however, is not limited thereto. Examples of metal species include, in addition to Si, Ti, Sn, Al, Zn, Zr, In, and mixtures thereof, but are not limited thereto. It is also possible to use any appropriate mixture of precursors of the oxides of the above metals.

In a case that a mixture of TEOS and MTES is used, the mixture ratio thereof can be 1:1, for example, in a molar ratio. The sol-gel material produces amorphous silica by performing hydrolysis and polycondensation reaction. An acid such as hydrochloric acid or an alkali such as ammonia is added in order to adjust pH of the solution as a synthesis condition. The pH is preferably not more than 4 or not less than 10. Water may be added to perform the hydrolysis. The amount of water to be added can be 1.5 times or more with respect to metal alkoxide species in the molar ratio. It is possible to use, as the sol-gel material, a material other than the silica. For example, a titanium-based material, a material based on indium tin oxide (ITO), ZnO, $ZrO_2$, $Al_2O_3$, and the like may be used.

Examples of the solvent of the sol-gel material include alcohols such as methanol, ethanol, isopropyl alcohol (IPA), and butanol; aliphatic hydrocarbons such as hexane, heptane, octane, decane, and cyclohexane; aromatic hydrocarbons such as benzene, toluene, xylene, and mesitylene; ethers such as diethyl ether, tetrahydrofuran, and dioxane; ketones such as acetone, methyl ethyl ketone, isophorone, and cyclohexanone; ether alcohols such as butoxyethyl ether, hexyloxyethyl alcohol, methoxy-2-propanol, and benzyloxyethanol; glycols such as ethylene glycol and propylene glycol; glycol ethers such as ethylene glycol dimethyl ether, diethylene glycol dimethyl ether, and propylene glycol monomethyl ether acetate; esters such as ethyl acetate, ethyl lactate, and γ-butyrolactone; phenols such as phenol and chlorophenol; amides such as N,N-dimethylformamide, N,N-dimethylacetamide, and N-methylpyrrolidone; halogen-containing solvents such as chloroform, methylene chloride, tetrachloroethane, monochlorobenzene, and dichlorobenzene; hetero-element containing compounds such as carbon disulfide; water; and mixture solvents thereof. Especially, ethanol and isopropyl alcohol are preferable. Further, a mixture of water and ethanol and a mixture of water and isopropyl alcohol are also preferable.

As an additive of the sol-gel material, it is possible to use polyethylene glycol, polyethylene oxide, hydroxypropylcellulose, and polyvinyl alcohol for viscosity adjustment; alkanolamine such as triethanolamine, β-diketone such as acetylacetone, β-ketoester, formamid, dimetylformamide, and dioxane, and the like, as a solution stabilizer.

<Coating step>

The substrate is coated with the sol-gel material prepared as described above (step S2 of Fig. 2). From a viewpoint of mass-production, it is preferred that the substrate be coated with the sol-gel material (the sol-gel material be applied on the substrate) at a predetermined position while a plurality of substrates are continuously transported. As the coating method, it is possible to use any coating method such as a bar coating method, a spin coating method, a spray coating method, a dip coating method, a die coating method, and an ink-jet method. The die coating method, the bar coating method, and the spin coating method are preferable, because the substrate having a relatively large area can be coated uniformly with the so-gel material and the coating can be quickly completed prior to gelation of the sol-gel material.

As the substrate, substrates made of inorganic materials such as glass, silica glass, and silicon substrates or substrates of resins such as polyethylene terephthalate (PET), polyethylene terenaphthalate (PEN), polycarbonate (PC), cycloolefin polymer (COP), polymethyl methacrylate (PMMA), polystyrene (PS), polyimide (PI), and polyarylate may be used. The substrate may be transparent or opaque. A relatively hard substrate is preferable from the perspective that the sol-gel material layer is formed on this substrate and further a functional layer is formed on this substrate when the optical substrate is incorporated into the device. Further, if a substrate having a concave and convex pattern obtained from this substrate is used for production of the organic EL element as will be described later, this substrate desirably has the heat resistance and the weather resistance to ultraviolet (UV) light and the like. In these respects, substrates made of inorganic materials such as glass, silica glass, and silicon substrates are more preferable. Since the inorganic materials are used as the sol-gel material coating the substrates, in a case that the substrate is made of the inorganic materials, the difference in refractive index between the substrate and the sol-gel material layer is small and unintended refraction and/or reflection in the optical substrate can be prevented. Thus, the substrates made of the inorganic materials are preferable also in these respects. It is allowable to perform a surface treatment or provide an easy-adhesion layer on the substrate in order to improve an adhesion property, and to provide a gas barrier layer in order to keep out moisture and/or gas such as oxygen. It is noted that, since a sol-gel material layer with a desired concave and convex pattern is formed in subsequent steps, the surface of the substrate (including the surface treatment or the easy-adhesion layer in case that the surface treatment or the easy-adhesion layer is present) may be flat, and the substrate itself does not have the desired concave and convex pattern. It is preferred that each substrate coated with the sol-gel material be transported as it is for the subsequent drying step and transfer step.

<Drying step>

After the coating step, the substrate is dried by being held or kept in the atmosphere or under reduced pressure so as to evaporate the solvent in the coating film (hereinafter also referred to as "sol-gel material layer" as appropriate) (step S3 of Fig. 2). In a case that the holding time of the substrate is short, the viscosity of the coating film is too low to transfer the pattern in the subsequent transfer step. In a case that the holding time of the substrate is too long, the polymerization reaction of the precursor proceeds too much and thereby the transfer cannot be performed in the transfer step. In case that the optical substrate is mass-produced, the holding time can be controlled as a time for transporting the substrate from the sol-gel material coating to the subsequent transfer step using the film-shaped mold. A holding temperature of the substrate in the drying step desirably stays constant in a range of 10 to 100 degrees Celsius, and more desirably stays constant in a range of 10 to 30 degrees Celsius. In a case that the holding temperature is higher than this range, the gelation reaction of the coating film proceeds rapidly before the transfer step, which is not preferable. In a case that the holding temperature is lower than this range, the gelation reaction of the coating film proceeds slowly before the transfer step, which reduces the productivity and is not preferable. After the sol-gel material coating, the polymerization reaction of the precursor proceeds as the evaporation of the solvent proceeds, and the physical property such as the viscosity of the sol-gel material also changes in a short time. The amount of vaporization of the solvent depends also on the amount of the solvent (concentration of the sol-gel material) used at the time of preparing the sol-gel material. For example, in a case that the sol-gel material is the silica precursor, the hydrolysis and condensation polymerization reaction of the silica precursor occurs as the gelation reaction and alcohol is generated in the sol-gel material through dealcoholization reaction. A volatile solvent such as the alcohol is used in the sol-gel material as the solvent. That is, the alcohol generated in the hydrolysis process and the alcohol existing as the solvent are included in the sol-gel material, and sol-gel reaction proceeds by removing them in the drying step. Therefore, it is desirable that the holding time and holding temperature be adjusted by taking the gelation reaction and the solvent used in the sol-gel material into consideration. In the drying step, the solvent in the sol-gel material evaporates simply by holding the substrate as it is. Thus, it is not indispensable to actively perform a drying operation such as heating and blowing. Leaving the substrate with the coating film as it is for a predetermined time or transporting said substrate in a predetermined time for subsequent steps are enough for drying the substrate. That is, the drying step is not indispensable for the substrate formation step.

<Transfer step>

After the time set as described above has elapsed, the film-shaped mold prepared in the step S0 is pressed against the coating film with the pressing roll (laminate roll) to transfer the concave and convex pattern of the film-shaped mold to the coating film on the substrate (step S4 of Fig. 2). For example, as shown in Fig. 4, it is possible to transfer the concave and convex pattern of the film-shaped mold 80a to the coating film (sol-gel material) 42 on the substrate 40 by sending the film-shaped mold 80a between the pressing roll 22 and the substrate 40 being transported immediately below the pressing roll 22. That is, in a case that the film-shaped mold 80a is pressed against the coating film 42 with the pressing roll 22, the film-shaped mold 80a is coated on the surface of the coating film 42 on the substrate 40 while the film-shaped mold 80a and the substrate 40 are synchronously transported. In this situation, by rotating the pressing roll 22 while pressing the pressing roll 22 against the back surface (surface on the side opposite to the surface in which the concave and convex pattern is formed) of the film-shaped mold 80a, the film-shaped mold 80a moves with the substrate 40 to adhere to the substrate 40. In order to send the long film-shaped mold 80a to the pressing roll 22, it is advantageous that the film-shaped mold 80a is fed directly from the film winding roll 87 (see Fig. 3) around which the long film-shaped mold 80a is wound in the step S0.

A roll process using such a pressing roll has the following advantages as compared with a pressing system: i) the period of time during which the mold and the coating film are brought in contact with each other in the roll process is shorter than that in the pressing system, and thus it is possible to prevent deformation of the pattern caused by the difference among coefficients of thermal expansion of the mold, the substrate, a stage on which the substrate is provided, and the like; ii) productivity is improved by the roll process and the productivity is further improved by use of the long film-shaped mold; iii) it is possible to prevent generation of bubbles of gas in the pattern caused by bumping of the solvent in the gel solution and/or it is possible to prevent a trace or mark of gas from being left; iv) it is possible to reduce transfer pressure and releasing force (peeling force) because of line contact with the substrate (coating film), and thereby making it possible to deal with a larger substrate readily; and v) no bubble is involved during the pressing. Since the flexible film-shaped mold is used as the mold in the manufacturing method of the present invention, when the concave and convex pattern of the mold is transferred to the sol-gel material layer 42 formed on the relatively hard substrate 40, the pattern of the mold can be uniformly pressed against the sol-gel material layer formed on the entire surface of the substrate. Accordingly, the concave and convex pattern of the mold can be faithfully transferred to the sol-gel material layer, thereby making it possible to suppress the occurrence of transfer omission and/or transfer failure.

In the transfer step, the film-shaped mold may be pressed against the coating film while the coating film is heated. As the method for heating the coating film, for example, the heating through the pressing roll may be performed, or the coating film may be heated directly or from the side of the substrate. In a case that the heating is performed through the pressing roll, a heating means may be provided in the pressing roll (transfer roll), and any heating means can be used. Although it is preferred that a heater be included in the pressing roll, the heater may be provided separately from the pressing roll. In any case, arbitrary pressing roll may be used provided that the coating film can be pressed while being heated. The pressing roll is preferably a roll of which surface is coated with a resin material with heat resistance, such as ethylene propylene diene rubber (EPDM), silicone rubber, nitrile rubber, fluororubber, acrylic rubber, and chloroprene rubber. A supporting roll may be provided to face the pressing roll while sandwiching the substrate therebetween in order to resist the pressure applied by the pressing roll. Alternatively, a support base supporting the substrate may be provided.

The heating temperature of the coating film at the time of the pressing may be in a range of 40 degrees Celsius to 150 degrees Celsius. In a case that the heating is performed by use of the pressing roll, the heating temperature of the pressing roll may be also in a range of 40 degrees Celsius to 150 degrees Celsius. By heating the pressing roll as described above, the mold can be easily released (peeled off) from the coating film against which the mold has been pressed, and thereby making it possible to improve the productivity. In a case that the heating temperature of the coating film or the pressing roll is less than 40 degrees Celsius, the mold can not be expected to be released (peeled off) from the coating film quickly. In a case that the heating temperature of the coating film or the pressing roll exceeds 150 degrees Celsius, the solvent used evaporates so rapidly that there is fear that the concave and convex pattern is not transferred sufficiently. By performing the pressing while heating the coating film, an effect similar to that obtained in pre-baking of the sol-gel material layer which will be described later can be expected.

After the mold is pressed against the coating film (sol-gel material layer), the coating film may be subjected to the pre-baking. In a case that the pressing is performed without heating the coating film, it is preferred that the pre-baking be performed. The pre-baking promotes gelation of the coating film to solidify the pattern, and thereby the pattern is less likely to be collapsed during the releasing. That is, the pre-baking has two roles of the reliable pattern formation and the improvement of releasing property (peeling property) of the mold. In a case that the pre-baking is performed, the heating is preferably performed at temperatures of 40 degrees Celsius to 150 degrees Celsius in the atmosphere.

<Releasing step>

The mold is released or peeled off from the coating film (sol-gel material layer) after the transfer step or the pre-baking step (step S5). Since the roll process is used as described above, the releasing force (peeling force) may be smaller than that of a plate-shaped mold used in the pressing system, and it is possible to easily release the mold from the coating film without remaining the coating film on the mold. In particular, since the pressing is performed while the coating film is heated, the reaction is more likely to progress, which facilitates the releasing the mold from the coating film immediately after the pressing. In order to promote the releasing property (peeling property) of the mold, it is possible to use a peeling roll (releasing roll). As shown in Fig. 4, by providing a peeling roll (releasing roll) 23 on the downstream side of the pressing roll 22 and supporting the film-shaped mold 80a while urging the film-shaped mold 80a toward the coating film 42 with the rotating peeling roll 23, a state in which the film-shaped mold 80a is attached to the coating film can be maintained by a distance between the pressing roll 22 and the peeling roll 23 (for a certain period of time). Then, by changing a path of the film-shaped mold 80a such that the film-shaped mold 80a is pulled up above the peeling roll 23 on the downstream side of the peeling roll 23, the film-shaped mold 80a is peeled off (released) from the coating film 42. The pre-baking or the heating may be performed during a period in which the film-shaped mold 80a is attached to the coating film. In a case that the peeling roll 23 is used, by peeling the coating film from the mold 80a while heating the coating film, for example, at temperatures of 40 degrees Celsius to 150 degrees Celsius, the coating film can be peeled more easily.

<Main baking step>

After the mold is released (peeled off) from the coating film (sol-gel material layer) 42 on the substrate 40, the coating film is subjected to the main baking (step S6 of Fig. 2). Hydroxyl group and the like contained in the layer of sol-gel material such as silica, which forms the coating film, is desorbed or eliminated by the main baking to further harden (solidify) the coating film. It is preferred that the main baking be performed at temperatures of 200 degrees Celsius to 1200 degrees Celsius for about 5 minutes to 6 hours. Accordingly, the coating film is cured, and thereby the substrate with the concave and convex pattern film which corresponds to the concave and convex pattern of the mold, that is, the substrate in which the sol-gel material layer having the concave and convex pattern is directly formed on the flat substrate, is obtained. In this situation, in a case that the sol-gel material layer is made of the silica, depending on a baking temperature and a baking time, the silica is amorphous, crystalline, or in a mixture state of the amorphous and the crystalline.

<Cleaning step>

The substrate 40 (light extraction substrate), in which the sol-gel material layer 42 having the concave and convex pattern is formed through the roll process, is cleaned.
The cleaning is performed to remove foreign substances and the like adhering to the substrate. For example, the substrate is mechanically cleaned in pure water by using a brush such as a roll-brush which is constructed by implanting, in the periphery of a rotational shaft, polypropylene, vinyl chloride, or the like processed to have a linear-shape or a strip-shape, and then an alkaline cleaner and an organic solvent are used to eliminate organic substances and the like. As the alkaline cleaner, it is possible to use, for example, an alkaline organic compound solution which is commercially available as Semico Clean (trade name), ethylamine, diethylamine, ethanolamine, and (2-hydroxyethyl) trimethyl-ammonium hydroxide (choline). As the organic solvent, it is possible to use, for example, acetone and isopropyl alcohol (IPA).
In addition to or instead of the above cleaning methods, ultrasonic cleaning may be performed. The ultrasonic cleaning can be performed, for example, for a few minutes to several tens of minutes by immersing the substrate in alcohols such as isopropyl alcohol, acetone, or the alkaline organic compound solution known, for example, as Semico Clean (trade name). In addition to or instead of the above cleaning methods, a UV/$O_3$ process may be performed.
In the present invention, since the concave and convex pattern of the optical substrate is made of the sol-gel material, the concave and convex pattern is relatively hard, has the resistance to the mechanical cleaning with the brush, and has the corrosion resistance to the alkaline cleaner and the organic solvent. Further, the concave and convex pattern of the sol-gel material 42 is more insusceptible to the ultrasonic cleaning or the UV/$O_3$ process as compared with the curable resin.

<First electrode formation step>

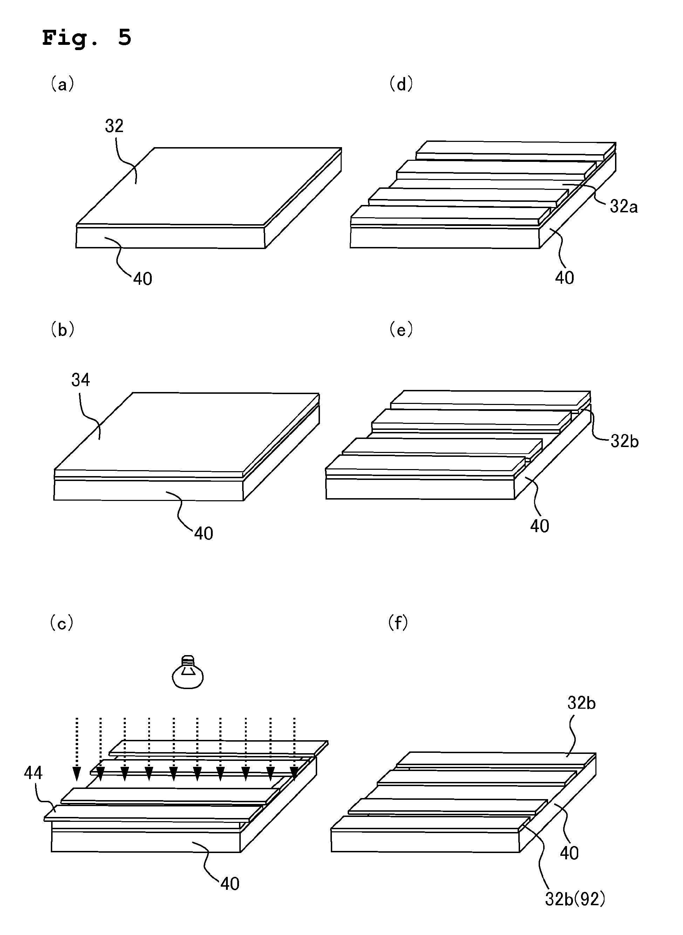

Subsequently, a transparent electrode 92 as the first electrode is stacked on the sol-gel material layer 42 on the cleaned substrate 40 to maintain the concave and convex structure formed on the surface of the sol-gel material layer 42 as shown in Fig. 6 (first electrode formation step P2 of Fig. 1). The formation process of the transparent electrode 92 will be explained while referring to Fig. 5(a)-(f). At first, as shown in Fig. 5(a), the film of an electrode material layer 32 forming the transparent electrode 92 is formed on the substrate 40. As the method for forming the film, any conventionally known method such as a vapor deposition method, a sputtering method, a CVD method, and a spray method can be employed as appropriate. Of these methods, the sputtering method is preferably employed from the viewpoint of improving the adhesion property. As the electrode material, for example, indium oxide, zinc oxide, tin oxide, indium-tin oxide (ITO) which is a composite material thereof, gold, platinum, silver, or copper can be used. Of these materials, ITO is preferable from the viewpoint of transparency and electrical conductivity. The thickness of the electrode material layer 32 (therefore, transparent electrode 92) is preferably in a range of 20 to 500 nm. In a case that the thickness is less than the lower limit, the electrical conductivity is more likely to be insufficient. In a case that the thickness exceeds the upper limit, there is possibility that the transparency is so insufficient that emitted EL light cannot be extracted to the outside sufficiently.

After forming the film of the electrode material layer 32 by the sputter method or the like, a photoresist 34 is applied on the electrode material layer 32 (the electrode material layer 32 is coated with a photoresist 34), as shown in Fig. 5(b), in order to form a desired electrode pattern by using a photolithography process (photoetching method). Next, as shown in Fig. 5(c), the photoresist 34 is exposed with UV light etc., via a mask 44 in which the electrode pattern is formed. Next, as shown in Fig. 5(d), the etching is performed on the photoresist 34 by a developer to remove a part of the photoresist 34, thereby exposing a part 32a of the electrode material layer 32. Next, as shown in Fig. 5(e), the exposed part 32a of the electrode material layer 32 is removed by wet etching with an etching liquid (etchant) such as hydrochloric acid to obtain a patterned electrode material layer 32b. Then, by removing the photoresist remaining on the electrode material layer 32b with a resist stripper, the patterned transparent electrode 92 can be obtained as shown in Fig. 5(f). The substrate is exposed to a high temperature of about 300 degrees Celsius at the time of the sputtering. It is desired that the UV/O$_3$ process be performed after cleaning the obtained transparent electrode with the brush and eliminating organic substances and the like by the alkaline cleaner and the organic solvent. The patterned transparent electrode 92 may be obtained by performing the step for forming the film of the electrode material layer 32 after the step for developing the photoresist shown in Fig. 5(d) and then removing the photoresist layer by lift-off (lift-off method).

In the transparent electrode formation step by using the photolithography process, a composition composing the photoresist includes organic substances such as ethyl lactate and propylene glycol methyl ether acetate (PGMEA) as a solvent. As the resist developer, it is used a solution and the like, of which major component is an organic base such as tetramethylammonium hydroxide (TMAH) solution and trimethyl (2-hydroxyethyl) ammonium hydroxide. In the wet etching of the electrode material, it is used an acid solution such as hydrochloric acid and oxalic acid. As the resist stripper, N-methyl-2-pyrrolidone (NMP), dimethylsulfoxide (DMSO), diethylene glycol monobuthyl ether, monoethanolamine, or the like is used. As described above, since the optical substrate with the concave and convex pattern is exposed to the organic solvent and the acid solvent such as the developer and the etching liquid in the transparent electrode formation step, the concave and convex pattern formed in the optical substrate should have the corrosion resistance thereto. In the present invention, since the concave and convex pattern is made of the sol-gel material, even when the organic solvent and the acid solvent are used in the electrode formation step, the concave and convex pattern is not corroded by the solvents. Further, no color deterioration occurs in the concave and convex pattern. The first electrode in the present invention is not limited to the transparent electrode, and the first electrode may be an electrode such as a metal electrode having no permeability to visible light etc., depending on the type of device and/or the use of device.

<Annealing step>

After the photolithography process, the patterned transparent electrode is subjected to the annealing, so that the crystallinity is increased to reduce a resistance value and improve a transmittance (annealing step P4 of Fig. 1). The annealing is generally performed in a heating furnace for about 10 minutes to 3 hours, and the annealing temperature generally ranges from 160 to 360 degrees Celsius, for example, the annealing temperature is 250 degrees Celsius. In the annealing step, although the optical substrate is exposed to an annealing process at a high temperature of about 250 degrees Celsius, since the sol-gel material layer 42 is usually made of the inorganic materials to have heat resistance, the annealing process has no effect on the sol-gel material layer 42. Finally, the annealed substrate is cleaned. A cleaning method similar to the above-mentioned cleaning method of the optical substrate can be used. For example, the cleaning with the brush and UV/O$_3$ process may be used.

<Thin film formation step>

Subsequently, an organic layer 94 as shown in Fig. 6 is stacked on the transparent electrode 92 (thin film formation step P5 of Fig. 1). The organic layer 94 is not particularly limited, provided that the organic layer 94 is usable as an organic layer of the organic EL element. As the organic layer 94, any known organic layer can be used as appropriate. The organic layer 94 may be a stacked body of various organic thin films. For example, the organic layer 94 may be a stacked body of a hole transporting layer 95, a light-emitting layer 96, and an electron transporting layer 97 as shown in Fig. 6. Here, examples of materials of the hole transporting layer 95 include aromatic diamine compounds such as phthalocyanine derivatives, naphthalocyanine derivatives, porphyrin derivatives, N,N'-bis(3-methylphenyl)-(1,1'-biphenyl)-4,4'-diamine (TPD), and 4,4'-bis[N-(naphthyl)-N-phenyl-amino]biphenyl($\alpha$-NPD); oxazole; oxadiazole; triazole; imidazole; imidazolone; stilbene derivatives; pyrazoline derivatives; tetrahydroimidazole; polyarylalkane; butadiene; and 4,4',4"-tris(N-(3-methylphenyl)N-phenylamino)triphenylamine (m-MTDATA). The materials of the hole transporting layer, however, are not limited thereto.

By providing the light emitting layer 96, a hole injected from the transparent electrode 92 and electron injected from a metal electrode 98 are recombined to occur light emission. Examples of materials of the light emitting layer 96 include metallo-organic complex such as anthracene, naphthalene, pyrene, tetracene, coronene, perylene, phthaloperylene, naphthaloperylene, diphenylbutadiene, tetraphenylbutadiene, coumarin, oxadiazole, bisbenzoxazoline, bisstyryl, cyclopentadiene, and aluminum-quinolinol complex (Alq3); tri-(p-terphenyl-4-yl)amine; 1-aryl-2,5-di(2-thienyl) pyrrole derivatives; pyran; quinacridone; rubren; distyrylbenzene derivatives; distyryl arylene derivatives; distyryl amine derivatives; and various fluorescent pigments or dyes. Further, it is preferred that light-emitting materials selected from the above compounds be mixed as appropriate and then are used. Furthermore, it is possible to preferably use a material system generating emission of light from a spin multiplet, such as a phosphorescence emitting material generating emission of phosphorescence and a compound including, in a part of the molecules, a constituent portion formed by the above materials. The phosphorescence emitting material preferably includes heavy metal such as iridium. A host material having high carrier mobility may be doped with each of the light-emitting materials as a guest material to generate the light emission using dipole-dipole interaction (Forster mechanism), or electron exchange interaction (Dexter mechanism). Examples of materials of the electron transporting layer 97 include heterocyclic tetracarboxylic anhydrides such as nitro-substituted fluorene derivatives, diphenylquinone derivatives, thiopyran dioxide derivatives, and naphthaleneperylene; and metallo-organic complex such as carbodiimide, fluorenylidene methane derivatives, anthraquino dimethane and anthrone derivarives, oxadiazole derivatives, and aluminum-quinolinol complex (Alq3). Further, in the oxadiazole derivatives mentioned above, it is also possible to use, as the electron transporting material, thiadiazole derivatives in which oxygen atoms of oxadiazole rings are substituted by sulfur atoms and quinoxaline derivatives having quinoxaline rings known as electron attractive group. Furthermore, it is also possible to use a polymeric material in which the above materials are introduced into a macromolecular chain or the above materials are made to be a main chain of the macromolecular chain. It is noted that the hole transporting layer 95 or the electron transporting layer 97 may also function as the light-emitting layer 96. In this case, there are two organic layers between the transparent electrode 92 and the metal electrode 98.

From the viewpoint of facilitating the electron injection from the metal electrode 98, it is allowable to provide, between the organic layer 94 and the metal electrode 98, as an electron injecting layer, a layer made of a metal fluoride such as lithium fluoride (LiF), a metal oxide such as $Li_2O_3$, a highly active alkaline earth metal such as Ca, Ba, or Cs, an organic insulating material, or the like. In addition, from the viewpoint of facilitating the hole injection from the transparent electrode 92, it is allowable to provide, between the organic layer 94 and the transparent electrode 92, as the hole injecting layer, a layer made of triazole derivatives; oxadiazole derivatives; imidazole derivatives; polyarylalkane derivatives; pyrazoline derivatives and pyrazolone derivatives; phenylenediamine derivatives; arylamine derivatives; amino-substituted chalcone derivatives; oxazole derivatives; styrylanthracene derivatives; fluorenon derivatives; hydrazone derivatives; stilbene derivatives; silazane derivatives; aniline copolymer; or a conductive polymer oligomer, in particular, thiophene oligomer, or the like.

In a case that the organic layer 94 is a stacked body formed of the hole transporting layer 95, the light-emitting layer 96, and the electron transporting layer 97, the thicknesses of the hole transporting layer 95, the light-emitting layer 96, and the electron transporting layer 97 are preferably in a range of 1 to 200 nm, in a range of 5 to 100 nm, and in a range of 5 to 200 nm, respectively. As a method for stacking the organic layer 94, any known method such as a vapor deposition method, a sputtering method, a spin coating method, and a die coating method can be employed as appropriate.

<Second electrode formation step>

Subsequently, as shown in Fig. 6, the metal electrode 98 as the second electrode is stacked on the organic layer 94 (second electrode formation step P6 of Fig. 1). Materials of the metal electrode 98 are not particularly limited, and a substance having a small work function can be used as appropriate. Examples of the materials include aluminum, MgAg, MgIn, and AlLi. The thickness of the metal electrode 98 is preferably in a range of 50 to 500 nm. In a case that the thickness is less than the lower limit, the electrical conductivity is more likely to be decreased. In a case that the thickness exceeds the upper limit, there is possibility that the repair or restoration is difficult when a short circuit between electrodes occurs. Any known method such as a vapor deposition method and a sputtering method can be adopted to stack the metal electrode 98. Accordingly, the organic EL element 200 having the structure as shown in Fig. 6 can be obtained.

After the second electrode formation step, it is allowable to perform a step of sealing the organic EL element 200 by using a sealing material to prevent deterioration due to moisture and/or oxygen; a step of cutting a panel of the organic EL element 200 as appropriate (scribe-and-break step); and/or a step of putting a polarizing plate to take a measure against specular reflection of the metal electrode.

In the above embodiment, the explanation has been given by citing the manufacture of the organic EL element as an example. The present invention, however, can be applied to a method for manufacturing another device such as a solar cell. For example, in a case that the solar cell is manufactured, the steps P1 to P4 (i.e., the substrate formation step P1, the cleaning step P2, the first electrode formation step S3, and the annealing step P4) may be substantially the same as those of the manufacturing process of the organic EL element. However, in the film formation step P5, depending on the type of the solar cell, it is formed a thin film including, for example, thin-film silicon using polysilicon and/or compound semiconductor; organic semiconductor; and a dye-sensitized structure in which an electrolyte layer is provided for semiconductor. In the second electrode formation step P6, the transparent electrode and/or metal electrode is/are formed.

Although the sol-gel material curable by heating is used in the method for manufacturing the optical substrate of the above embodiment, instead of this, it is allowable to use a photo-curable sol-gel material. In such a case, it is possible to adopt, for example, a method in which photo-acid generator such as hexafluorophosphate aromatic sulfonium salt which generates acid by light is used, or a method in which chemical modification (chelation) is caused by adding $\beta$-diketone represented by acetylacetone to a sol solution and the chemical modification is removed by being irradiated with light. In a case that the photo-curable sol-gel material is used for the sol-gel material layer, after the mold is pressed against the coating film (sol-gel material layer) in the transfer step, the coating film may turn into a gel (be cured) by being irradiated with light instead of the pre-baking of the coating film. Further, in the main baking step, after the mold is released from the coating film on the substrate, the coating film can be cured by being irradiated with light instead of the main-baking of the coating film.

In addition to the manufacture of the organic EL and the solar cell, the method for manufacturing the device of the present invention can be applied to any device, provided that the device is manufactured through the steps P1 to P6 (i.e., the substrate formation step P1, the cleaning step P2, the first electrode formation step S3, the annealing step P4, the thin film formation step P5, and the second electrode formation step S6). For example, the method for manufacturing the device of the present invention can be applied to the manufacture of a liquid crystal display and a touch panel.

<Manufacturing apparatus for optical substrate>

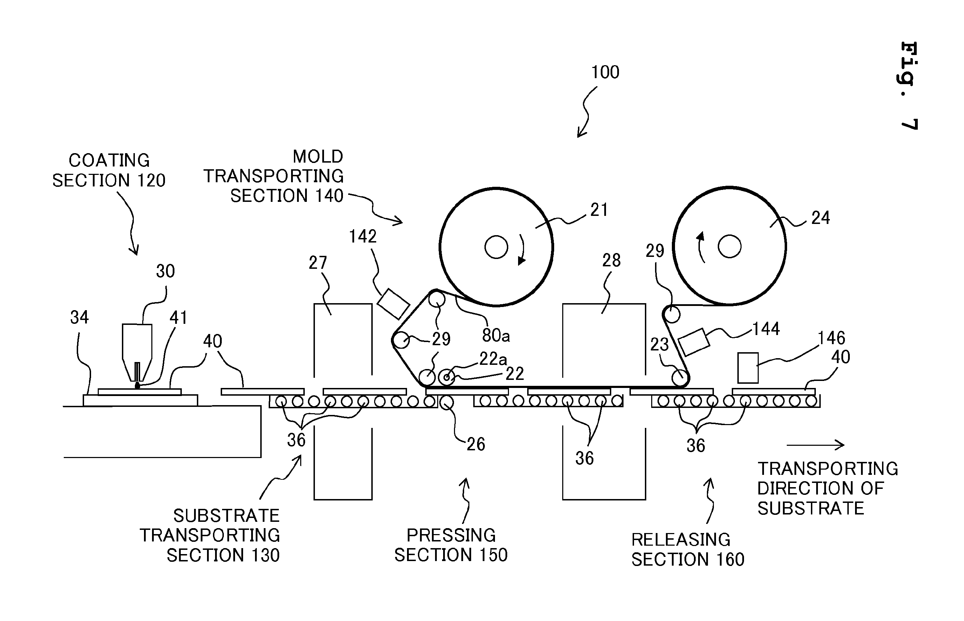

In order to perform the method for manufacturing the optical substrate of the present invention, it is possible to use, for example, an optical-substrate manufacturing apparatus (second unit) 100 manufacturing the optical substrate, as shown in Fig. 7. The optical-substrate manufacturing apparatus 100 mainly includes a coating section (coating-film forming section) 120 for coating the substrate 40 with the sol-gel material; a substrate transporting section 130 for transporting the substrate; and a mold transporting section 140 for transporting the film-shaped mold 80a. The mold transporting section 140 includes a pressing section 150 by which the film-shaped mold 80a is pressed against and transferred to the substrate 40 and a releasing section (peeling section) 160 which releases (peels off) the film-shaped mold 80 from the substrate 40.

The coating section 120 includes a substrate stage 34 which is movable while holding the substrate 40 and a die coater 30 which is positioned above the substrate stage and coats the substrate 40 with a sol-gel material 41 (applies a sol-gel material 41 on the substrate 40). The substrate transporting section 130 includes a plurality of rotating rolls 36 aligned in a transporting direction of the substrate (from the left side to the right side in Fig. 7) and transports the substrate 40 placed on the rotating rolls 36 in the transporting direction by driving to rotate the rotating rolls. The substrate transporting section 130 further includes a heating section 27 for drying the substrate 40 coated with the sol-gel material while the substrate 40 being transported.

The mold transporting section 140 mainly includes a mold feeding roll 21 which feeds the long film-shaped mold 80a; a pressing roll 22 which is arranged at a predetermined position on a transport path of the substrate to press the film-shaped mold 80a to the side of the coating film (not shown) formed on the substrate 40; a peeling roll (releasing roll) 23 which is provided on the downstream side of the pressing roll 22 to peel off (release) the film-shaped mold 80a, after a state in which the film-shaped mold 80a is pressed against the coating film on the substrate 40 is maintained over a predetermined distance; a mold winding roll 24 which is provided on the downstream side of the peeling roll 23 to wind or roll up the film-shaped mold; and transporting rolls 29 which transport the film-shaped mold 80a in an advancing direction of the film-shaped mold 80a. The mold feeding roll 21 and the mold winding roll 24 are rotatably mounted on support bases (not shown) so that the rolls 21 and 24 are detachable. Regarding the mold feeding roll 21, it is advantageous that the film winding roll 87 (see Fig. 3), on which the film-shaped mold 80a manufactured by the roll process apparatus 70 is wound, is transported to the apparatus 100 as appropriate and is directly used as the mold feeding roll 21.

A supporting roll 26 is provided to face the pressing roll 22 in the pressing section 150. The supporting roll 26 presses the substrate 40 from the lower side of the substrate in a state that the film-shaped mold 80a and the substrate 40 are sandwiched between the supporting roll 26 and the pressing roll 22, and the supporting roll 26 is rotationally driven to feed the substrate 40 to the downstream side in a substrate transporting direction. A heater 22a is provided in the pressing roll 22. The heater may be provided also in the supporting roll 26. In the releasing section 160, the peeling roll 23 is provided on a transport path of the film-shaped mold 80a and the peeling of the film-shaped mold 80a from the substrate 40 is promoted by pulling the film-shaped mold 80a upward using the transporting roll 29 disposed on the downstream side of the peeling roll 23 in the substrate transporting direction. A heating furnace (heater) 28 is provided between the pressing section 150 and the releasing section 160. It is possible to use, for example, an infrared heater, hot-air heating, and a hot plate as the heating furnace 28. The optical-substrate manufacturing apparatus 100 further includes an electricity-removing unit 142 for removing electricity from the film-shaped mold 80a fed from the mold feeding roll 21; an electricity-removing unit 144 for removing electricity from the film-shaped mold 80a before being rolled on the mold winding roll 24; and an electricity-removing unit 146 for removing electricity from the substrate 40 from which the film-shaped mold 80a is peeled off.

The optical-substrate manufacturing apparatus 100 includes a control section (not shown) which comprehensively controls the operation of the entire apparatus and respective operations of the coating section 120, the mold transporting section 140 provided with the pressing section 150 and the releasing section 160, and the substrate transporting section 130. The control section controls driving speeds of the substrate transporting section 130, the mold transporting section 140, and the pressing roll 22 so that the substrate 40 transported by the substrate transporting section 130 is transported in synchronization with the film-shaped mold 80a transported by the mold transporting section 140 when passing through the pressing section 150. Further, the optical-substrate apparatus 100 may include an inspection device for observing the thickness and state of the coating film formed by the coating section 120, an inspection device for observing the concave and convex pattern of the coating film after the releasing (peeling) of the film-shaped mold 80a, and the like.

An explanation will be given about the operation for processing the substrate 40 with the optical-substrate manufacturing apparatus 100. In the coating section 120, the substrate is coated uniformly with the sol-gel material by applying the sol-gel material 41 on the substrate using the die coater 30 while moving the substrate stage 34 holding the substrate 40 in the transporting direction. Subsequently, the substrate 40 on which the coating film made of the sol-gel material is formed is transferred onto the rotating rolls 36 arranged on the upstream side of the mold transporting section 140, and then the substrate 40 is transported to the pressing section 150, especially, the pressing roll 22 provided at a predetermined position. The sol-gel material dries during this transportation. Meanwhile, in the mold transporting section 140, the film-shaped mold 80a is fed from the mold feeding roll 21, passes through the electricity-removing unit 142 provided between the transporting rolls 29 to remove the electricity from the film-shaped mold 80a, and then arrives at the pressing section 150 via the transporting rolls 29. In the pressing section 150, the pressing roll 22 heated to temperatures of 40 degrees Celsius to 150 degrees Celsius presses the film-shaped mold 80a transported thereunder or therebelow against the substrate 40 in a state that the film-shaped mold 80a overlaps with the substrate 40. Accordingly, the concave and convex pattern of the film-shaped mold 80a is pressed against the coating film (sol-gel material) on the substrate 40 to perform the transfer of the pattern. Further, the gelation of the coating film progresses by the heating with the pressing roll 22. Subsequently, the substrate 40 to which the concave and convex pattern has been transferred by the pressing roll 22 is transported to the releasing section 160 after going through the heating furnace 28 with the film-shaped mold 80a being pressed against the substrate 40. In the heating furnace 28, the substrate 40 is heated to temperatures of 40 degrees Celsius to 150 degrees Celsius in order to facilitate the peeling (releasing) of the film-shaped mold 80a from the coating film. In the releasing section 160, the film-shaped mold 80a is pulled upward by the mold winding roll 24 via the transporting roll 29 when passing through the peeling roll 23, so that the film-shaped mold 80a is peeled off (released) from the coating film 42. Then, the electricity is removed from the film-shaped mold 80a by the electricity-removing unit 144 and the film-shaped mold 80a is rolled on the mold winding roll 24. The substrate 40 from which the film-shaped mold 80a is peeled off goes out of the optical-substrate manufacturing apparatus 100 after the electricity is eliminated from the substrate 40 by the electricity-removing unit 146. Accordingly, it is obtained the substrate 40 having the coating film to which the concave and convex pattern of the film-shaped mold 80a has been transferred. After this, the substrate 40 on which the pattern is formed is subjected to the main baking in an oven (not shown) or the like. The oven for the main baking may be provided in the apparatus 100.

In the optical-substrate manufacturing apparatus 100, a peeling angle may be adjusted by appropriately controlling or regulating the installation position of the peeling roll 23 and/or the position of the mold winding roll 24 which winds or rolls up the mold via the peeling roll 23. It is possible to use any other driving means such as a movable table which moves while supporting the substrate, instead of the supporting roll 26. Further, although the peeling roll 23 is used to maintain the state in which the concave and convex pattern of the film-shaped mold 80a is pressed against the coating film 42 with the pressing roll 22, it is allowable to use any other supporting member such as a plate-shaped member having a smooth surface and a corner with a curved surface, instead of the peeling roll 23, in order to maintain the above state. The optical-substrate manufacturing apparatus 100 as the second unit may include the roll process apparatus 70 as the first unit shown in Fig. 3. For example, the roll process apparatus 70 as the first unit may be integrally incorporated in the optical-substrate manufacturing apparatus 100 as the second unit so that the film winding roll 87 of the roll process apparatus 70 may be directly used as the mold feeding roll 21 of the optical-substrate manufacturing apparatus 100. In this case, it can be configured such that a rotating mechanism for driving the film winding roll 87 is controlled by the control device of the optical-substrate manufacturing apparatus 100 to switch a rotating direction. Or, the optical-substrate manufacturing apparatus 100 as the second unit may include the roll process apparatus 70 as the first unit, which is provided separately from the optical-substrate manufacturing apparatus 100. In this case, the film winding roll 87 obtained by rolling the film-shaped mold 80a thereon using the roll process apparatus 70 is transported to a position at which the mold feeding roll 21 of the optical-substrate manufacturing apparatus 100 is provided, and the film winding roll 87 can be used as the mold feeding roll 21. The optical-substrate manufacturing apparatus 100 may be separated from the roll process apparatus 70 as needed, and one of or both of them may be used at a proper place.

Hereinbelow, an explanation will be made about modified embodiments of the optical-substrate manufacturing apparatus of the above embodiment.

<First modified embodiment>

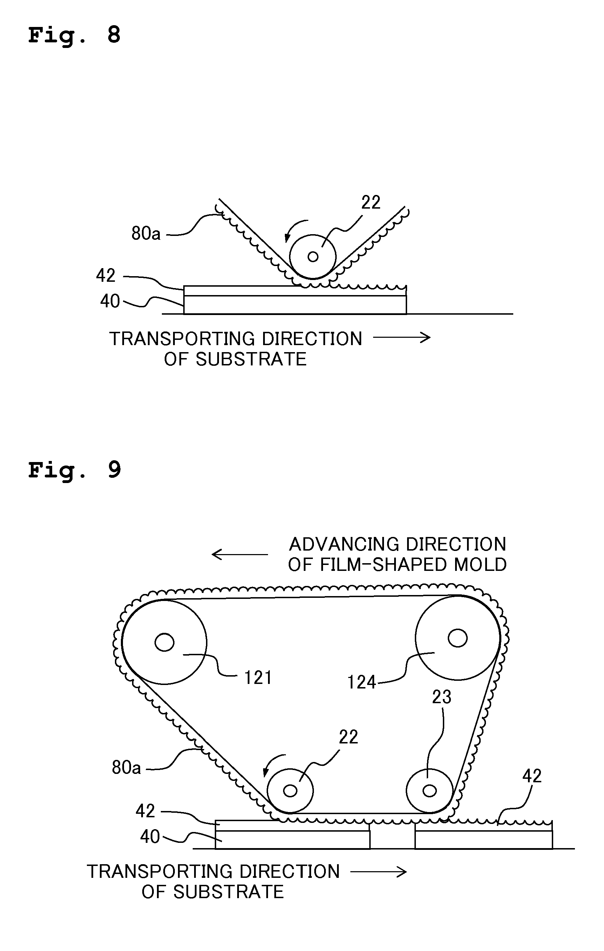

Although the peeling roll is provided in the optical-substrate manufacturing apparatus 100 of the above embodiment, the peeling roll may be omitted as shown in Fig. 8. In the apparatus shown in Fig. 8, the film-shaped mold 80a fed from the mold feeding roll 21 (see Fig. 7) is pressed against the coating film 42 with the hot pressing roll 22, and then the film-shaped mold 80a is wound or lifted with the mold winding roll 24 (see Fig. 7) positioned above the substrate 40. By heating the pressing roll 22 and/or using any other heating means, the peeling (releasing) of the mold from the coating film immediately after the pressing is promoted and the pre-baking of the coating film can be performed.

<Second modified embodiment>

Although the end portions of the film-shaped mold 80a are respectively wound on the mold feeding roll 21 and the mold winding roll 24 in the optical-substrate manufacturing apparatus 100 of the above embodiment, the film-shaped mold 80a may be formed to be an endless belt as shown in Fig. 9. By making the film-shaped mold 80a the endless belt, a mold feeding roll 121 is not required to be exchanged when the film-shaped mold 80a is completely wound off from the mold feeding roll 121, and a mold winding roll 124 is not required to be exchanged when the film-shaped mold 80a is completely wound on the mold winding roll 124.

<Third modified embodiment>

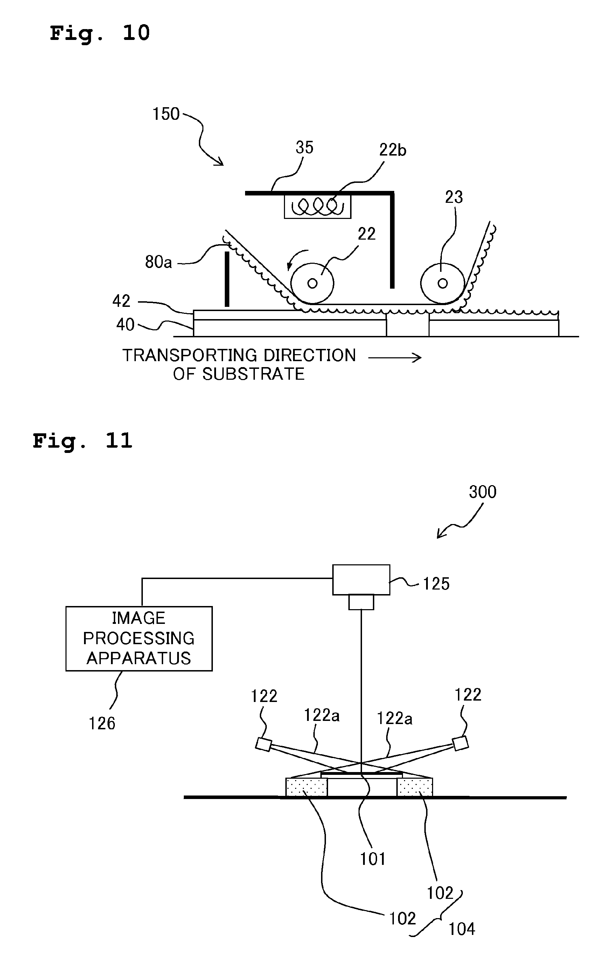

Although the heater 22a is provided in the pressing roll 22 in the optical-substrate manufacturing apparatus 100 of the above embodiment, the configuration as shown in Fig. 10 may be adopted instead of the installation of the heater for heating the pressing roll 22. As shown in Fig. 10, a heater 22b is not provided in the pressing roll 22, but in a heat zone 35 arranged at the periphery of the pressing roll 22 of the pressing section 150. Since the heater is provided in the heat zone 35, the inside of the heat zone is maintained at a heating temperature. In this case, the coating film 42 is subjected to the pre-baking in the heat zone 35. The heater may be provided not only in the heat zone 35 but also in the pressing roll 22 and/or the supporting roll 26 (see Fig. 7). As another modified embodiment of installation of the heater, instead of providing the heater 22a in the pressing roll 22, the heater 22a may be provided in the supporting roll supporting roll 26 (see Fig. 7). In this case, the coating film 42 is subjected to the pre-baking by heat generated from the heater 22a provided in the supporting roll 26. Alternatively, the heater 22a may be provided both in the pressing roll 22 and in the supporting roll 26.

The substrate, in (on) which the pattern made of the sol-gel material layer is formed through the roll process as described above, can be used as, for example, a diffraction-grating substrate for organic EL element, a wire grid polarizer, an antireflection film, and an optical element for providing an effect of a confinement of light within a solar cell by being placed on the photoelectric conversion surface side of the solar cell. Or, the pattern may be transferred to yet another resin by using the substrate having the pattern as the mold (mother die). In this case, the transferred resin pattern is an inverted pattern of the pattern on the substrate. Thus, it is allowable to produce a mold as a replica of the substrate by transferring the transferred inverted pattern to yet another resin. Each of the molds can be subjected to an electroforming process using Ni and the like to form a metallic mold. The use of each of the molds enables efficient mass production of an optical component such as the diffraction-grating substrate for organic EL element. Although the sol-gel material is cured by heat in the optical-substrate manufacturing apparatus of the above embodiment, the sol-gel material may be cured by being irradiated with light using the photo-curable sol-gel material. In this case, the heating roll (heater) 22a may not be used. A light-radiating machine may be provided instead of the heating furnace 28.

Examples

In the following description, the method for manufacturing the device of the present invention will be specifically explained with examples and comparative examples. The present invention, however, is not limited to the following examples and comparative examples.

[Example 1]

In this Example, a diffraction grating substrate is manufactured first, and then an organic EL element is manufactured by using this diffraction grating substrate. First, a mold having a concave and convex surface is manufactured by using the BCP method in order to manufacture the diffraction grating substrate first.

<Manufacture of diffraction grating mold>

It was prepared a block copolymer produced by Polymer Source Inc., which was made of polystyrene (hereinafter referred to as "PS" in an abbreviated manner as appropriate) and polymethyl methacrylate (hereinafter referred to as "PMMA" in an abbreviated manner as appropriate) as described below.

Mn of PS segment= 868,000
Mn of PMMA segment= 857,000
Mn of block copolymer = 1,725,000
Volume ratio between PS segment and PMMA segment (PS:PMMA)= 53:47
Molecular weight distribution (Mw/Mn)= 1.30
Tg of PS segment= 96 degrees Celsius
Tg of PMMA segment= 110 degrees Celsius

The volume ratio of the first polymer segment and the second polymer segment (first polymer segment: second polymer segment) in each block copolymer was calculated on the assumption that the density of polystyrene was 1.05 $g/cm^3$, the density of polymethyl methacrylate was 1.19 g/ $cm^3$. The number average molecular weights (Mn) and the weight average molecular weights (Mw) of polymer segments or polymers were measured by using gel permeation chromatography (Model No: "GPC-8020" manufactured by Tosoh Corporation, in which TSK-GEL SuperH1000, SuperH2000, SuperH3000, and SuperH4000 were connected in series). The glass transition temperatures (Tg) of polymer segments were measured by use of a differential scanning calorimeter (manufactured by Perkin-Elmer under the product name of "DSC7"), while the temperature was raised at a rate of temperature rise of 20 degrees Celsius/min over a temperature range of 0 degrees Celsius to 200 degrees Celsius. The solubility parameters of polystyrene and polymethyl methacrylate were 9.0 and 9.3, respectively (see Kagaku Binran Ouyou Hen (Handbook of Chemistry, Applied Chemistry), 2nd edition).

Toluene was added to 150 mg of the block copolymer and 38 mg of Polyethylene Glycol 4000 manufactured by Tokyo Chemical Industry Co., Ltd. (Mw= 3000, Mw/Mn= 1.10) as polyethylene oxide so that the total amount thereof was 10g, followed by dissolving them. Then, the solution was filtrated or filtered through a membrane filter having a pore diameter of 0.5 $\mu$m to obtain a block copolymer solution. The obtained block copolymer solution was applied, on a polyphenylene sulfide film (TORELINA manufactured by TORAY INDUSTRIRES, INC.) as a base member, in a film thickness of 200 to 250 nm, by spin coating. The spin coating was performed at a spin speed of 500 rpm for 10 seconds, and then performed at a spin speed of 800 rpm for 30 seconds. The thin film formed by the spin coating was left at room temperature for 10 minutes until the thin film was dried.

Subsequently, the base member on which the thin film was formed was heated for 5 hours in an oven of 170 degrees Celsius (first annealing process). Concavities and convexities were observed on a surface of the heated thin film, and it was found out that micro phase separation of the block copolymer forming the thin film was caused.

The thin film heated as described above was subjected to an etching process as described below to selectively decompose and remove PMMA on the base member. The thin film was irradiated with ultraviolet rays at an irradiation intensity of $30J/cm^2$ (wavelength of 365 nm) by use of a high pressure mercury lamp. Then, the thin film was immersed in acetone, and was subjected to cleaning with ion-exchanged water, followed by being dried. As a result, there was formed, on the base member, a concave and convex pattern clearly deeper than the concavities and convexities which appeared on the surface of the thin film by the heating process.

Next, the base member was subjected to a heating process (second annealing process) for 1 hour in an oven of 140 degrees Celsius so that the concave and convex pattern formed by the etching process was deformed to have a chevron-shaped structure (process for forming a shape of chevrons).

A thin nickel layer of about 10 nm was formed as a current seed layer by sputtering on the surface of the thin film, for which the process for forming the shape of chevrons had been performed. Subsequently, the base member with the thin film was subjected to an electroforming process (maximum current density: 0.05A/cm$^2$) in a nickel sulfamate bath at a temperature of 50 degrees Celsius to precipitate nickel until the thickness of nickel became 250 $\mu$m. The base member with the thin film was mechanically peeled off from the nickel electroforming body obtained as described above. Subsequently, the nickel electroforming body was immersed in Chemisol 2303 manufactured by The Japan Cee-Bee Chemical Co., Ltd., followed by being cleaned while being stirred for 2 hours at 50 degrees Celsius. Thereafter, polymer component(s) adhering to a part of the surface of the electroforming body was(were) removed by repeating the following process three times. That is, the nickel electroforming body was coated with an acrylic-based UV curable resin; and the acrylic-based UV curable resin coating the nickel electroforming body was cured; and then the cured resin was peeled off.

Subsequently, the nickel electroforming body was immersed in OPTOOL HD-2100TH manufactured by Daikin Industries, Ltd. for about 1 minute and was dried, and then stationarily placed overnight. The next day, the nickel electroforming body was immersed in OPTOOL HD-TH manufactured by Daikin Industries, Ltd. to perform an ultrasonic cleaning process for about 1 minute. Accordingly, a nickel mold (nickel substrate) for which a mold-release treatment had been performed was obtained.

Subsequently, a PET substrate (easily-adhesion PET film manufactured by Toyobo Co., Ltd., product name: COSMOSHINE A-4100) was coated with a fluorine-based UV curable resin. Then, the fluorine-based UV curable resin was cured by irradiation with ultraviolet rays at 600 mJ/cm$^2$, with the obtained nickel mold being pressed against the PET substrate. After curing of the resin, the nickel mold was peeled off from the cured resin. Accordingly, a diffraction grating mold made of the PET substrate with the resin film to which the surface profile of the nickel mold was transferred was obtained.

<Manufacture of diffraction grating substrate>

2.5 g of tetraethoxysilane (TEOS) and 2.1 g of methyltriethoxysilane (MTES) were added by drops to a mixture of 24.3 g of ethanol, 2.16 g of water, and 0.0094 g of concentrated hydrochloric acid, followed by being stirred for 2 hours at a temperature of 23 degrees Celsius and humidity of 45 % to obtain a sol-gel material. The sol-gel material was applied on a soda-lime glass plate of 15 x 15 x 0.11 cm by bar coating. Doctor Blade (manufactured by Yoshimitsu Seiki Co., Ltd.) was used as a bar coater. The doctor blade was designed so that the film thickness of the coating film was 5 $\mu$m. However, the doctor blade was adjusted so that the film thickness of the coating film was 40 $\mu$m by sticking an imide tape having a thickness of 35 $\mu$m to the doctor blade. After the elapse of 60 seconds from the sol-gel material coating, the diffraction grating mold manufactured as described above was pressed against the coating film on the glass plate by use of the pressing roll heated to 80 degrees Celsius while the pressing roll was moved and rotated. After the completion of pressing against the coating film, the mold was manually peeled off (released) from the coating film on the glass plate and the coating film on the glass plate was subjected to the main baking by being heated for 60 minutes in an oven of 300 degrees Celsius. Accordingly, it was obtained the diffraction grating substrate in which the pattern of the diffraction grating mold was transferred to the sol-gel material. As the pressing roll, it was used a roll which included a heater therein and had the outer periphery covered with heat-resistant silicon of a thickness of 4 mm, the roll having a diameter ($\varphi$) of 50 mm and a length of 350 mm in an axial direction of the shaft.

An analysis image of the shape of the concavities and convexities on the surface of the diffraction grating substrate was obtained by use of an atomic force microscope (a scanning probe microscope equipped with an environment control unit "Nanonavi II Station/E-sweep" manufactured by Hitachi High-Tech Science Corporation). Analysis conditions of the atomic force microscope were as follows.

Measurement mode: dynamic force mode
Cantilever: SI-DF40 (material: Si, lever width: 40 $\mu$m, diameter of tip of chip: 10 nm) Measurement atmosphere: in air
Measurement temperature: 25 degrees Celsius

A concavity and convexity analysis image was obtained as described above by performing a measurement in a randomly selected measuring region of 3 $\mu$m square (length: 3 $\mu$m, width: 3 $\mu$m) in the diffraction grating substrate. Distances between randomly selected concave portions and convex portions in the depth direction were measured at 100 points or more in the concavity and convexity analysis image, and the average of the distances was calculated as the average value (average height) of a depth distribution of the concavities and convexities. The average value of the depth distribution of the concave and convex pattern obtained by the analysis image in this example was 56 nm.

A concavity and convexity analysis image was obtained as described above by performing a measurement in a randomly selected measuring region of 3 $\mu$m square (length: 3 $\mu$m, width: 3 $\mu$m) in the diffraction grating substrate. The obtained concavity and convexity analysis image was subjected to a flattening process including primary inclination correction, and then subjected to two-dimensional fast Fourier transform processing. Thus, a Fourier-transformed image was obtained. It was confirmed that the Fourier-transformed image showed a circular pattern substantially centered at an origin at which an absolute value of wavenumber was 0 $\mu m^{-1}$, and that the circular pattern was present within a region where the absolute value of wavenumber was in a range of 10 $\mu m^{-1}$ or less.

The circular pattern of the Fourier-transformed image is a pattern observed due to gathering of bright spots in the Fourier-transformed image. The term "circular" herein means that the pattern of the gathering of the bright spots looks like a substantially circular shape, and is a concept further including a case where a part of a contour looks like a convex shape or a concave shape. The pattern of the gathering of the bright spots may look like a substantially annular shape, and this case is expressed as the term "annular". It is noted that the term "annular" is a concept further including a case where a shape of an outer circle or inner circle of the ring looks like a substantially circular shape and a case where a part of the contour of the outer circle or the inner circle of the ring looks like a convex shape or a concave shape. Further, the phrase "the circular or annular pattern is present within a region where an absolute value of wavenumber is in a range of 10 $\mu m^{-1}$ or less (more preferably 1.25 to 10 $\mu m^{-1}$, further preferably 1.25 to 5 $\mu m^{-1}$) " means that 30% or more (more preferably 50% or more, further more preferably 80% or more, and particularly preferably 90% or more) of bright spots forming the Fourier-transformed image are present within a region where the absolute value of wavenumber is in a range of 10 $\mu m^{-1}$ or less (more preferably 1.25 to 10 $\mu m^{-1}$, and further preferably 1.25 to 5 $\mu m^{-1}$). Regarding the relationship between the pattern of the concave and convex structure and the Fourier-transformed image, the followings have been appreciated. That is, in a case that the concave and convex structure itself has neither the pitch distribution nor the directivity, the Fourier-transformed image appears to have a random pattern (no pattern). In a case that the concave and convex structure is entirely isotropic in an XY direction and has the pitch distribution, a circular or annular Fourier-transformed image appears. In a case that the concave and convex structure has a single pitch, the annular shape appeared in the Fourier-transformed image tends to be sharp.

The two-dimensional fast Fourier transform processing on the concavity and convexity analysis image can be easily performed by electronic image processing by use of a computer equipped with software for the two-dimensional fast Fourier transform processing.

As a result of the image analysis of the obtained Fourier-transformed image, the wavenumber 2.38 $\mu m^{-1}$ was the most intensive. That is, the average pitch was 420 nm. The average pitch could be obtained as follows. For each of points of the Fourier-transformed image, the intensity and distance (unit: $\mu m^{-1}$) from the origin of the Fourier-transformed image were obtained. Then, the average value of the intensity was obtained for the points each having the same distance from the origin. As described above, a relationship between the distance from the origin of the Fourier-transformed image and the average value of the intensity was plotted, a fitting with a spline function was carried out, and the wavenumber of the peak intensity was regarded as the average wavenumber ($\mu m^{-1}$). For the average pitch, it is allowable to make a calculation by another method, for example, a method for obtaining the average pitch of the concavities and convexities as follows. That is, a concavity and convexity analysis image is obtained by performing a measurement in a randomly selected measuring region of 3 $\mu m$ square (length: 3 $\mu m$, width: 3 $\mu m$) in the diffraction grating, then the distances between randomly selected adjacent convex portions or between randomly selected adjacent concave portions are measured at 100 points or more in the concavity and convexity analysis image, and then an average of these distances is determined.

<Manufacture of organic EL element>

The glass substrate with the pattern made of the sol-gel material layer as the diffraction grating obtained as described above was cleaned with a brush in pure water to remove foreign matter and the like adhering thereto. Then, organic matter and the like adhering to the glass substrate was removed by ultrasonic cleaning by use of Semico Clean as an alkaline cleaner and IPA as an organic solvent. A transparent electrode was formed on the cleaned substrate by patterning as follows (see Fig. 5(a)-(f)). At first, a film of ITO having a thickness of 120 nm was formed by a sputtering method at a temperature of 300 degrees Celsius. Then, the ITO film was coated with a photoresist (produced by TOKYO OHKA KOGYO CO., LTD., TFR-H) by the spin coating method, and exposure was performed with light having the wavelength of 365 nm via a mask pattern for the transparent electrode. Thereafter, the exposed portion of the photoresist was removed by etching by use of 2.5 % concentration TMAH solution as a developer, so that a part of ITO is exposed. Next, the exposed area of ITO was removed by using 18 % concentration hydrochloric acid as an etching liquid. Finally, the residual photoresist was removed by using a mixed solution of DMSO and NMP (DMSO:NMP = 1:1) as stripper. Accordingly, the transparent electrode having the predetermined pattern was obtained. After cleaning the obtained substrate having the transparent electrode with the brush and then removing the organic matter and the like adhering to the substrate by the ultrasonic cleaning using the organic solvent (IPA), the UV/O$_3$ process was performed and the substrate was put in the heating furnace heated to 250 degrees Celsius to perform the annealing process for 20 minutes in the ambient atmosphere.

On the transparent electrode processed as described above, a hole transporting layer (4,4',4" tris(9-carbazole)triphenylamine, thickness: 35 nm), a light emitting layer (tris(2-phenylpyridinato)iridium(III) complex-doped

4,4',4"tris(9-carbazole)triphenylamine, thickness: 15 nm; tris(2-phenylpyridinato)iridium(III) complex-doped 1,3,5-tris(N-phenylbenzimidazole-2-yl)benzene, thickness: 15 nm), an electron transporting layer (1,3,5-tris(N-phenylbenzimidazole-2-yl)benzene, thickness: 65 nm), and a lithium fluoride layer (thickness: 1.5 nm) were each stacked by a vapor deposition method. Further, a metal electrode (aluminum, thickness: 50 nm) was formed as the uppermost layer by a vapor deposition method. Accordingly, the organic EL element as shown in Fig. 6 was obtained.

The directivity of light emission of the organic EL element obtained in this example was evaluated by the following method. That is, the organic EL element in a luminescent state was visually observed in all the directions (directions of all around 360°). Neither particularly bright sites nor particularly dark sites were observed when the organic EL element obtained in this Example was observed in any of the directions of all around 360°, and the brightness was uniform in all the directions. In this way, it was shown that the directivity of light emission of the organic EL element of the present invention was sufficiently low.

In Example 1, the temperature at the time of forming the film of the transparent electrode (ITO) of the organic EL element was 300 degrees Celsius. Although it is allowable that the temperature at the time of forming the film of the transparent electrode is lower than 300 degrees Celsius, the transparent electrode is desired to have low resistivity, and the film formation is preferably performed at high temperature to increase crystallinity. In a case that the temperature during the film formation is low, which is about 100 degrees Celsius, the ITO film formed on the substrate is relatively amorphous and has inferior specific resistance, and an adhesion property between the substrate and the ITO thin film is inferior. Although the concave and convex pattern formed of a general UV curable resin and the like has difficulty in withstanding a film formation process at high temperature, the use of sol-gel material which is an example of ceramic allows the concave and convex pattern go through the film formation process at high temperature. Therefore, the method of the present invention is also suitable for the manufacture of the substrate (diffraction grating) for the organic EL element. Further, in a case that the curable resin as described above is kept for a long period under high temperature because of, for example, the generation of heat at the time of emitting light, there is fear that the curable resin deteriorates to cause yellow discoloration and/or generate gas. Thus, it is difficult to use the organic EL element using the resin substrate for a long period of time. In contrast, the organic EL element provided with the substrate made of the sol-gel material is less likely to deteriorate.

[Example 2]

A diffraction grating substrate was manufactured in the same manner as Example 1, except that the pressing roll, which was heated to 150 degrees Celsius, was used. As a result, the pattern transfer could be performed similarly to Example 1, and it was confirmed that the average value of the depth distribution of the concave and convex pattern in the diffraction grating substrate was 56 nm and the average pitch was 420 nm.

[Example 3]

In this Example, a diffraction grating substrate in which the concave and convex pattern was formed of the sol-gel material (hereinafter referred to as "sol-gel pattern substrate") and a diffraction grating substrate in which the same concave and convex pattern was formed of resin (hereinafter referred to as "resin pattern substrate") were prepared respectively. Then, the sol-gel pattern substrate was compared with the resin pattern substrate with respect to the resistance to cleaning, chemicals, and heat in the manufacturing process of the organic EL element, and results thereof were verified. As the sol-gel pattern substrate, the diffraction grating substrate manufactured in Example 1 was used. The resin pattern substrate was manufactured as follows. A soda-lime glass substrate of 15 x 15 x 0.11 cm was coated with a fluorine-based UV curable resin. Then, the fluorine-based UV curable resin was cured by irradiation with ultraviolet rays at 600 mJ/cm$^2$, with the diffraction grating mold manufactured in Example 1 being pressed against the substrate. After curing of the resin, the diffraction grating mold was peeled off from the cured resin. Accordingly, the resin pattern substrate to which the surface profile of the diffraction grating mold was transferred was obtained.

The sol-gel pattern substrate and the resin pattern substrate prepared as described above were subjected to processes simulating the cleaning process, the photolithography process, the ITO etching process, the photoresist stripping step, and the annealing step, those of which were performed before the thin film formation step in the manufacturing process of the organic EL element. Then, the concave and convex pattern on each of the substrates before and after each of the processes was observed. Although the transparent electrode layer, etc., is stacked on the substrate in the actual manufacturing process of the organic EL element, in order to examine the effects of chemicals and environmental temperature on the substrate in each of the processes, no layer was stacked on the substrate and the substrate was exposed to various environments in the following processes.

(1) Cleaning step

In order to evaluate the resistance of each of the diffraction grating substrates (the sol-gel pattern substrate and the resin pattern substrate) in the cleaning step performed before the thin film formation step, the following three cleaning experiments were performed on the sol-gel pattern substrate and the resin pattern substrate.

<Ultrasonic cleaning>

An ultrasonic washer or cleaner (produced by Kokusai Denki L Tec:KK) was filled with isopropyl alcohol (IPA), and each of the sol-gel pattern substrate and the resin pattern substrate was immersed in the isopropyl alcohol to be cleaned for 20 minutes at output power of 200 W under room temperature. Subsequently, acetone was used as a cleaning liquid instead of the isopropyl alcohol to perform the ultrasonic cleaning of each of the sol-gel pattern substrate and the resin pattern substrate under the similar conditions of those of the case using the isopropyl alcohol. Further, Semico Clean 56 was used as the cleaning liquid instead of the isopropyl alcohol, and each of the sol-gel pattern substrate and the resin pattern substrate was immersed in Semico Clean 56 to be subjected to the ultrasonic cleaning for 10 minutes at output power of 200 W under room temperature.

<Cleaning with brush>

The sol-gel pattern substrate and the resin-pattern substrate were each cleaned by using a small single-substrate brush cleaner (produced by IMAI SEISAKUSHO Co., Ltd.). A roll brush in which nylon having diameter of 100 $\mu$m was put into the surface of a roll was used as the brush. The cleaning with the brush was performed under the following conditions: rotation speed of the roll brush of 500 rpm; pressure of the roll brush against the substrate of 0.2 MPa; and a substrate transport speed of 1 m/min. Pure water was used as cleaning water and two roll brushes were used.

<UV/$O_3$ Cleaning>

The sol-gel pattern substrate and the resin pattern substrate were each accommodated in a UV/$O_3$ cleaner (PL16-110: SEN LIGHTS CORPORATION). Then, ozone was generated by UV light (wavelengths: 184.9 nm, 253.7 nm) by use of a low pressure mercury lamp and each of the substrates was irradiated with UV light at 15 mW/cm$^2$ for 10 minutes.

(2) Photolithography step

In order to examine the resistance of the sol-gel pattern substrate and the resin pattern substrate in the photolithography step, a beaker was filled with ethyl lactate included in the photoresist, and each of the sol-gel pattern substrate and the resin pattern substrate was immersed in the ethyl lactate for 20 minutes under room temperature. Further, a similar experiment was carried out by using PGMEA instead of the ethyl lactate. Furthermore, in order to examine the resistance of the sol-gel pattern substrate and the resin pattern substrate to a photoresist developer, each of the sol-gel pattern substrate and the resin pattern substrate was immersed in 2.5% of TMAH as the developer for 20 minutes under room temperature.

(3) ITO etching step

In order to examine the resistance of the sol-gel pattern substrate and the resin pattern substrate in the step of etching and patterning an ITO electrode material, each of the substrates was immersed in 18% of hydrochloric acid for 20 minutes at ordinary temperature.

(4) Resist stripping step

In order to examine the resistance of the sol-gel pattern substrate and the resin pattern substrate to the stripper used in the step of stripping the remaining photoresist in the lithography step, each of the substrates was immersed in NMP for 20 minutes at ordinary temperature. A similar experiment was carried out by using DMSO instead of NMP.

(5) Annealing step

In order to examine the resistance of the sol-gel pattern substrate and the resin pattern substrate in the annealing step performed after the patterning of the transparent electrode, each of the substrates was placed in the heating furnace heated to 250 degrees Celsius for 20 minutes in the ambient atmosphere.

<Method for evaluation of substrates>

In order to evaluate the resistance of the sol-gel pattern substrate and the resin pattern substrate in each of the processes of the five steps, an inspection of unevenness and a SPM inspection were performed on each of the substrates before and after each of the processes. As the inspection of unevenness, the following method was adopted to observe the overall state of the concave and convex pattern on the surface of each of the substrates before and after each of the experiments.

An inspection apparatus 300 shown in Fig. 11 was provided in a dark room, and a substrate 101 (each of the sol-gel pattern substrate and the resin pattern substrate) before and after each of the processes in the above five steps was attached to the inspection apparatus 300 to observe the intensity distribution of scattered light of the substrate under the following conditions. The inspection apparatus 300 includes a stage device 104 on which the substrate 101 is placed; a pair of highly directional LED bar illuminations 122 (produced by CCS Inc., LDL2-119 x 16BL) irradiating the substrate 101 with light; a digital camera 125 taking the image of light reflected from the substrate; and an image processing device 126 performing image processing and analysis of the obtained image. The substrate 101 having a size of 30 mm x 30 mm and a thickness of 0.7 mm was arranged to bridge between extend over a pair of black blocks 102 of the stage device 104, each of black blocks 102 having a rectangular parallelepiped shape. The height of the blocks 102 was 40 mm and the distance between the blocks 102 was 27 mm. The pair of LED bar illuminations 122 had a light-emission central wavelength of 470 nm and an area of light-emitting section of 119 mm x 160 mm. The pair of LED bar illuminations 122 was provided at a position having a height of 160 mm from the floor surface in a state of being inclined toward the floor surface at 10° from a horizontal state. The distance between the two LED bar illuminations 122 was 307 mm. The digital camera 125 was arranged at a position having a distance of 770 mm from the surface of the substrate. Light emission of the pair of LED bar illuminations was performed at a maximum output (each 5.7 W) and an image of the substrate 101 was obtained. The type of the digital camera 125 and the imaging conditions were as follows:

Camera: Canon EOS Kiss X3
Lens: EF-S18-55 mm F3.5-5.6 IS
Shutter speed: 1/100 seconds
ISO sensitivity: 3200
Aperture value: F5.6
White balance: Standard
Picture style: Standard
Pixel value: 0 to 255

Blue pixel values were sampled or extracted from the image obtained by the digital camera, and the blue pixel values were displayed as a gray scale. Further, as shown in Fig. 12(a), only the pixel values on a line L1, which extended in an X direction at a substantially central position of the image in a Y direction, were sampled to be outputted as profile of the pixel values with respect to pixel positions in the X direction. Only the pixel values in the portion to be made into the organic EL element (within the frame depicted by broken lines in Fig. 12(a)) were outputted as the cross-section profile. Fig. 12(b) shows an example of profile of the pixel values obtained from the sol-gel pattern substrate with respect to the pixel positions in the X direction. In the example shown in Fig. 12(b), the average pixel value was 113. It has been found out through preliminary test(s) that unevenness of luminance was conspicuous when the diffraction grating substrate, in which the change in average pixel value was 20 % before and after each of the resistance tests, was used in the organic EL element. Therefore, a case in which the change in average pixel value was less than 20 % before and after each of the resistance tests was evaluated as "+" (satisfactory), and a case in which the change in average pixel value was 20 % or more before and after each of the resistance tests was evaluated as "-" (unsatisfactory). The evaluation results are shown in TABLE 1.

In the SPM inspection, the surface condition and depths of concavities and convexities of the concave and convex pattern on the surface of each of the substrates were inspected by use of a scanning microscope. In the SPM inspection, it was used the atomic force microscope (the scanning probe microscope equipped with the environment control unit "Nanonavi II Station/E-sweep" manufactured by Hitachi High-Tech Science Corporation.) used in Example 1. Analysis conditions of the atomic force microscope were the same as those in Example 1. A concavity and convexity analysis image was obtained as described above by performing a measurement in a randomly selected measuring region of 3 $\mu$m square (length: 3 $\mu$m, width: 3 $\mu$m) in the substrate. Distances between randomly selected concave portions and convex portions in the depth direction were measured at 100 points or more in the concavity and convexity analysis image, and the average of the distances was calculated as the average value (average height) of depth distribution of the concavities and convexities. In a case that the change in average value of depth distribution of the concavities and convexities was 20 % or less as compared with the substrate before each of the resistance tests, the substrate was evaluated to be satisfactory or acceptable. In a case that the change in average value of depth distribution of the concavities and convexities was 20% or more, the substrate was evaluated to be unsatisfactory or defective. Further, in a case that abnormal projections and/or surface roughness, which had not been observed before each of the resistance tests, was/were observed in the image for evaluation, the substrate was evaluated to be unsatisfactory or defective. In a case that no abnormality or defect was observed in the image for evaluation, the substrate was evaluated to be satisfactory or acceptable. The case in which both the average value of depth distribution of the concavities and convexities and the image for evaluation were evaluated to be satisfactory or acceptable, the substrate was evaluated to be satisfactory, which is expressed as "+" and cases other than the above case were evaluated to be satisfactory, which is expressed as "-". The evaluation results are shown in TABLE 1.

[TABLE 1]

| Names of steps | Contents of processes | Chemicals, etc. | Conditions | Resin substrate | | Sol-gel substrate | |
|---|---|---|---|---|---|---|---|
| | | | | Observation of unevenness | SPM | Observation of unevenness | SPM |
| Cleaning step | Ultrasonic cleaning | IPA | Normal temperature 20 min, 200 W | + | + | + | + |
| | | Acetone | Normal temperature 20 min, 200 W | + | + | + | + |
| | | Semico Clean 56 | Normal temperature 10 min, 200 W | + | + | + | + |
| | Cleaning with brush | Pure water (Single-substrate cleaner) | 500 rpm, 1 m/min, 0.2 MPa | + | - | + | + |
| | UV/$O_3$ process | SEN (PL16-110) | 10 min, 15 mW/cm$^2$ | - | - | + | + |
| Photolithography step | Resist coating | Ethyl lactate | Normal temperature 20 min, immersion | + | + | + | + |
| | | PGMEA | Normal temperature 20 min, immersion | + | + | + | + |
| | Development process | TMAH (2.5%) | Normal temperature 20 min, immersion | + | + | + | + |
| ITO etching step | Etching process | Hydrochloric Acid | Normal temperature 20 min, immersion | + | - | + | + |
| Resist stripping step | Stripping process | NMP | Normal temperature 20 min, immersion | + | + | + | + |
| | | DMSO | Normal temperature 20 min, immersion | + | + | + | + |
| Annealing step | Annealing process | Ambient atmosphere | 250 degree Celsius 20 min | - | - | + | + |

Regarding the resin pattern substrate processed by the UV/O$_3$ cleaning in the cleaning step, there were observed that the change in average pixel value was 20 % or more in the observation of unevenness, and that the average value of depth distribution of the concavities and convexities decreased by 20 % or more in the SPM observation. It is assumed that these results were brought about by erosion of the concave and convex pattern of the resin during the UV/O$_3$ cleaning. On the other hand, regarding the sol-gel pattern substrate, no significant difference was found out between observation results before and after the UV/O$_3$ cleaning. In the ITO etching process, it was observed in the SPM observation that the resin pattern substrate had abnormal projections on the concave and convex surface thereof. It is assumed that this result was brought about by generation of abnormal precipitate generated by reaction between the resin and the hydrochloric acid in the ITO etching process. On the other hand, regarding the sol-gel pattern substrate, no significant difference was found out between observation results before and after the ITO etching process. Further, regarding the resin pattern substrate after the annealing process, there were observed that the change in average pixel value was 20 % or more in the observation of unevenness, and that the average value of depth distribution of the concavities and convexities on the concave and convex surface decreased by 20 % or more in the SPM observation. It is assumed that there results were brought about by melting of a part of the concave and convex pattern of the resin owing to high temperature in the annealing process. On the other hand, regarding the sol-gel pattern substrate, no significant difference was found out between observation results before and after the annealing process.

[Comparative Example 1]

The resin pattern substrate manufactured in Example 3 was used as the diffraction grating substrate to produce the organic EL element in the same manner as Example 1.

[Evaluation of light emission efficiency of organic EL element]

The light emission efficiency of the organic EL element obtained in each of Example 1 and Comparative Example 1 was measured by the following method. That is, voltage was applied to the obtained organic EL element, and then the applied voltage V and a current I flowing through the organic EL element were measured with a source measurement instrument (manufactured by ADC CORPORATION, R6244), and a total luminous flux amount L was measured with a total flux measurement apparatus manufactured by Spectra Co-op. From the thus obtained measured values of the applied voltage V, the current I, and the total luminous flux amount L, a luminance value L' was calculated. Here, for the current efficiency, the following calculation formula (F1) was used:

$$\text{Current efficiency} = (\text{L'/I}) \times \text{S} \qquad (\text{F1})$$

and, for the power efficiency, the following calculation formula (F2) was used:

$$\text{Power efficiency} = (\text{L'/I/V}) \times \text{S} \qquad (\text{F2})$$

Accordingly, the current efficiency and the power efficiency of the organic EL element were calculated. In the above formulae, S is a light-emitting or luminescent area of the element. Noted that the value of the luminance L' was calculated on the assumption that light distribution characteristic of the organic EL element followed Lambert's law, and the following calculation formula (F3) was used:

$$\text{L'} = \text{L}/\pi/\text{S} \qquad (\text{F3})$$

The current efficiency of the organic EL element of Example 1 at a luminance of 1000 cd/m$^2$ was 111.1 cd/A. Further, the power efficiency of the organic EL element of Example 1 at a luminance of 1000 cd/m$^2$ was 97.7 lm/W. The organic EL element of Comparative Example 1 could not be evaluated as the element, because the resin pattern was broken by mechanical damage at the time of the cleaning with the brush, damage at the time of the UV/O$_3$ cleaning, and/or damage caused by heat at the time of the ITO film formation. An organic EL element manufactured on a glass substrate having no pattern was prepared as a comparative sample, and the current efficiency and power efficiency of the organic EL element were measured. As a result, the current efficiency at a luminance of 1000 cd/m$^2$ was 74.5 cd/A, and the power efficiency at the same luminance of 1000 cd/m$^2$ was 58.4 lm/W.

As described above, since the concave and convex pattern of the optical substrate used for the method for manufacturing the device according to the present invention is made of the sol-gel material, this optical substrate has various advantages as compared with the substrate having the concave and convex pattern made of the curable resin, as will be described below. The sol-gel material has a superior mechanical strength. Thus, even when the cleaning with the brush is performed on the substrate and the surface of the concave and convex pattern after formation of the transparent electrode in the manufacturing process of the organic EL element, damage, the adhesion of foreign matter, the projection on the transparent electrode, and the like are less likely to occur, and it is possible to suppress any element failure (defect of an optical element) which would be otherwise caused by the damage and the like. Therefore, the organic EL element, as the device obtained by the method of the present invention is superior to the organic EL element in which the curable resin substrate is used, in terms of the mechanical strength of the substrate with the concave and convex pattern.

The substrate made of the sol-gel material produced according to the method of the present invention has satisfactory chemical resistance. Therefore, the substrate of the present invention is relatively corrosion-resistant to the alkaline fluid and the organic solvent used in the cleaning steps of the substrate and the transparent electrode, which makes it possible to use various cleaning liquids. Further, the alkaline developer or the acidic etching liquid is sometimes used at the time of the patterning of the transparent substrate as described above, and the substrate of the present invention is also corrosion-resistant to such developer and etching liquid. In this respect, the substrate of the present invention has an advantage over the curable resin substrate having relatively low resistance to the alkaline fluid and the acid solution.

The substrate made of the sol-gel material produced according to the method of the present invention has superior heat resistance. Thus, it is also possible to resist a high-temperature atmosphere of the sputtering step in the process for forming the transparent electrode of the organic EL element. Further, the substrate made of the sol-gel material produced according to the method of the present invention is superior to the curable resin substrate in terms of the UV resistance and the weather resistance. Therefore, the substrate of the present invention is also resistant to the UV/$O_3$ cleaning process after the formation of the transparent electrode. Accordingly, by using the substrate made of the sol-gel material, no influence is exerted on the substrate in the processes forming the semiconductor film and the organic film.

In a case that the organic EL element, as the device produced by the method of the present invention, is used outside or outdoors, it is possible to suppress the deterioration due to sunlight as compared with the case in which the curable resin substrate is used. Further, in a case that the curable resin as described above is kept for a long period under high temperature because of, for example, the generation of heat at the time of emitting light, there is fear that the curable resin deteriorates to cause yellow discoloration and/or generate gas. Thus, it is difficult to use the organic EL element using the resin substrate for a long period of time. In contrast, the organic EL element provided with the substrate made of the sol-gel material is less likely to deteriorate.

In the above description, the present invention was explained by using Examples. The manufacturing method and manufacturing apparatus for the optical substrate and the method for manufacturing the device according to the present invention, however, are not limited to the above embodiments, and can be appropriately modified within the range of technical ideas described in the claims. In the above Examples, for example, although the diffraction grating substrate was manually manufactured by using the bar coater, the oven, and the like, the diffraction grating substrate, however, may be manufactured by using the optical substrate manufacturing apparatus as shown in Fig. 4. Further, although the sol-gel material cured by heat was used in the above Examples, instead of this, the photo-curable sol-gel material may be used. In this case, the coating film (sol-gel material) can be cured by being irradiated with light other than the baking of the coating film.

**Industrial Applicability**

The manufacturing method and manufacturing apparatus for the optical substrate according to the present invention are capable of manufacturing the optical substrate with high throughput while performing the minute pattern transfer accurately and reliably. The method for manufacturing the device according to the present invention utilizes the optical substrate with the minute concave and convex pattern, which is manufactured by the manufacturing method and the manufacturing apparatus according to the present invention and is resistant to the process for manufacturing the element (device) into which the optical substrate is incorporated because the optical substrate with the minute concave and convex pattern has excellent in the heat resistance, the weather resistance, and the corrosion resistance. Therefore, the method for manufacturing the device according to the present invention makes it possible to extend the service life of the element. Accordingly, the method for manufacturing the device according to the present invention can produce, with high throughput, various devices, such as the organic EL element and the solar cell, which are excellent in the heat resistance, the weather resistance, and the corrosion resistance.

**Reference Signs List:**

21: mold feeding roll; 22: pressing roll; 23: peeling roll; 24: mold winding roll; 26: supporting roll; 29: transporting roll; 30: die coater; 32: electrode material layer; 34: photoresist; 35: heat zone; 40: substrate; 42: coating film (sol-gel material layer); 44: mask; 70: roll process apparatus; 72: film feeding roll; 74: nip roll; 76: releasing roll; 78: transporting roll; 80: substrate film; 80a: film-shaped mold; 82: die coater; 85: UV radiation light source; 86: substrate film transporting system; 87: film winding roll; 90: transfer roll; 92: transparent electrode; 94: organic layer; 95: hole transporting layer; 96: light-emitting layer; 97: electron transporting layer; 98: metal electrode; 100: optical substrate manufacturing apparatus; 101: diffraction grating substrate; 102: block; 104: stage device; 120: coating section; 122: LED bar illumination; 125: digital camera; 126: image processing device; 130: substrate transporting section; 140: mold transporting section; 142, 144, 146: electricity-removing unit; 150: pressing section; 160: releasing section; 200: organic EL element; 300: inspection apparatus

**Claims**

1.  A method for manufacturing an optical substrate having a concave and convex pattern, comprising:

    a step of preparing a long film-shaped mold having a surface of the concave and convex pattern;
    a step of forming a coating film made of a sol-gel material on a substrate;
    a step of transferring the surface of the concave and convex pattern of the film-shaped mold to the coating film by arranging the surface of the concave and convex pattern to face the coating film and pressing a pressing roll against a surface of the film-shaped mold on a side opposite to the surface of the concave and convex pattern;
    a step of releasing the film-shaped mold from the coating film; and
    a step of curing the coating film to which the concave and convex pattern has been transferred.

2.  The method for manufacturing the optical substrate according to claim 1, wherein the step of curing the coating film includes curing the coating film by baking the coating film.

3.  The method for manufacturing the optical substrate according to claim 1 or 2, wherein the step of preparing the long film-shaped mold includes:

    coating a long film-shaped base member with a concave-convex forming material;
    performing a roll transfer of the concave and convex pattern to the concave-convex forming material by pressing a transfer roll having the concave and convex pattern against the concave-convex forming material coating the long film-shaped base member while rotating the transfer roll; and
    curing the concave-convex forming material to which the concave and convex pattern has been transferred through the roll transfer so as to obtain the long film-shaped mold in a roll shape.

4.  The method for manufacturing the optical substrate according to claim 3, wherein the film-shaped base member having the cured concave-convex forming material is wound around a film winding roll.

5.  The method for manufacturing the optical substrate according to claim 3, wherein the concave and convex pattern of the transfer roll is transferred while the film-shaped base member is transported by using a film feeding roll feeding the film-shaped base member and a film winding roll winding or rolling up the film-shaped base member.

6.  The method for manufacturing the optical substrate according to claim 4 or 5, wherein the long film-shaped mold in the roll shape wound around the film winding roll moves with being fed to the pressing roll.

7.  The method for manufacturing the optical substrate according to any one of claims 1 to 6, wherein the released long film-shaped mold is wound around a mold winding roll.

8.  The method for manufacturing the optical substrate according to any one of claims 1 to 7, wherein the pressing roll is pressed against the surface of the film-shaped mold on the side opposite to the surface of the concave and convex pattern while the concave-convex forming material being heated.

9.  The method for manufacturing the optical substrate according to any one of claims 1 to 8, wherein the pressed concave-convex forming material is heated in the releasing step or between the transfer step and the releasing step.

10. The method for manufacturing the optical substrate according to any one of claims 1 to 9, wherein the surface of the concave and convex pattern of the long film-shaped mold is successively pressed against coating films on a plurality of substrates with the pressing roll while continuously feeding the long film-shaped mold under the pressing roll and transporting each of the substrates to the pressing roll at a predetermined time interval with the coating film made of the sol-gel material being formed.

11. The method for manufacturing the optical substrate according to any one of claims 1 to 10, wherein the concave and convex pattern of the film-shaped mold is an irregular concave and convex pattern in which an average pitch of concavities and convexities is in a range of 100 to 1500 nm and an average value of a depth distribution of the concavities and convexities is in a range of 20 to 200 nm.

12. An apparatus for manufacturing an optical substrate, comprising:

a coating-film forming section configured to form a coating film made of a sol-gel material on a substrate;
a substrate transporting section configured to transport the substrate on which the coating film is formed to a predetermined position;
a mold transporting section which includes a mold feeding roll configured to feed a long film-shaped mold having a surface of a concave and convex pattern and a mold winding roll configured to wind or roll up the long film-shaped mold, and is configured to transport the film-shaped mold to the predetermined position by continuously feeding the film-shaped mold from the mold feeling roll to the predetermined position and winding the film-shaped mold around the mold wining roll; and
a pressing roll rotatably arranged at the predetermined position and configured to press a part of the surface of the concave and convex pattern of the long film-shaped mold, which is fed to the predetermined position by the mold transporting section, against the coating film on the substrate which is transported to the predetermined position by the substrate transporting section.

13. The apparatus for manufacturing the optical substrate according to claim 12, further comprising a peeling roll configured to peel the part of the surface of the concave and convex pattern of the long film-shaped mold pressed with the pressing roll from the coating film on the substrate.

14. The apparatus for manufacturing the optical substrate according to claim 12 or 13, further comprising a heating means configured to heat the coating film on the substrate against which the part of the surface of the concave and convex pattern of the film-shaped mold is pressed.

15. The apparatus for manufacturing the optical substrate according to claim 14, wherein the heating means is a heater provided in the pressing roll.

16. The apparatus for manufacturing the optical substrate according to any one of claims 12 to 15, further comprising a heating means configured to heat the coating film when the film-shaped mold is released from the coating film.

17. The apparatus for manufacturing the optical substrate according to any one of claims 12 to 16, further comprising a supporting roll provided at a position to face the pressing roll and configured to support the substrate from a lower side of the substrate.

18. The apparatus for manufacturing the optical substrate according to any one of claims 12 to 17, wherein the coating-film forming section includes a substrate stage configured to move the substrate while holding the substrate.

19. The apparatus for manufacturing the optical substrate according to any one of claims 12 to 18, wherein the concave and convex pattern of the film-shaped mold is an irregular concave and convex pattern in which an average pitch of concavities and convexities is in a range of 100 to 1500 nm and an average value of a depth distribution of the concavities and convexities is in a range of 20 to 200 nm.

20. The apparatus for manufacturing the optical substrate according to any one of claims 12 to 19, further comprising a roll process apparatus configured to form the long film-shaped mold, the roll process apparatus including: a transporting system configured to transport a substrate film; a coating unit configured to coat the substrate film being transported with a concave-convex forming material; a transfer roll provided on a downstream side of the coating unit and configured to transfer the concave and convex pattern to the concave-convex forming material; and a radiation light source configured to emit light to the substrate film.

21. The apparatus for manufacturing the optical substrate according to claim 20, wherein the transporting system includes a film feeding roll configured to feed the substrate film; a nip roll configured to urge the substrate film toward the transfer roll; a releasing roll configured to facilitate releasing of the substrate film from the transfer roll; and a film winding roll configured to wind or roll up the substrate film to which the concave and convex pattern has been transferred.

22. The apparatus for manufacturing the optical substrate according to claim 21, wherein the film winding roll around which the substrate film is wound is used as the mold feeding roll configured to feed the film-shaped mold.

23. A method for manufacturing a device provided with an optical substrate having a concave and convex pattern, comprising:

   a substrate formation step of forming a substrate with a predetermined concave and convex pattern by coating the substrate with a sol-gel material and transferring the concave and convex pattern to the sol-gel material coating the substrate;
   a cleaning step of cleaning the substrate with the concave and convex pattern;
   a first electrode formation step of forming a first electrode on the cleaned substrate by patterning;
   an annealing step of annealing the substrate on which the first electrode is formed;
   a thin film formation step of forming a thin film on the first electrode; and
   a second electrode formation step of forming a second electrode on the thin film.

24. The method for manufacturing the device according to claim 23, wherein at least one of ultrasonic cleaning, cleaning with a brush, and UV/$O_3$ cleaning is performed in the cleaning step.

25. The method for manufacturing the device according to claim 23 or 24, wherein the patterning is performed by using an acid solvent or an alkaline solvent, and the patterning includes formation of a first electrode layer, resist coating, exposure and development, etching of the first electrode layer, and stripping of the resist.

26. The method for manufacturing the device according to any one of claims 23 to 25, wherein the annealing is performed at a temperature in a range of 160 degrees Celsius to 360 degrees Celsius.

27. The method for manufacturing the device according to any one of claims 23 to 26, wherein the device is an organic EL element, the first electrode is a transparent electrode, the thin film includes an organic layer, and the second electrode is a metal electrode.

28. The method for manufacturing the device according to any one of claims 23 to 27, wherein the device is a solar cell, the first electrode is a transparent electrode, the thin film includes a semiconductor layer, and the second electrode is a metal electrode.

29. The method for manufacturing the device according to any one of claims 23 to 28, wherein the concave and convex pattern formed on the substrate is an irregular concave and convex pattern used for scattering or diffracting light in which an average pitch of concavities and convexities is in a range of 100 to 1500 nm and an average value of a depth distribution of the concavities and convexities is in a range of 20 to 200 nm.

30. The method for manufacturing the device according to any one of claims 23 to 29, wherein the substrate is a glass substrate and the sol-gel material includes a silica precursor.

31. The method for manufacturing the device according to any one of claims 23 to 30, further comprising baking of the sol-gel material at a temperature of 300 degrees Celsius or more after coating the substrate with the sol-gel material and transferring the predetermined concave and convex pattern to the so-gel material coating the substrate.

32. The method for manufacturing the device according to any one of claims 23 to 31, wherein the substrate formation step includes:

   a step of preparing a long film-shaped mold having a surface of the concave and convex pattern;
   a step of forming a coating film made of the sol-gel material on the substrate;
   a step of transferring the surface of the concave and convex pattern of the film-shaped mold to the coating film by arranging the surface of the concave and convex pattern of the film-shaped mold to face the coating film and pressing a pressing roll against a surface of the film-shaped mold on a side opposite to the surface of the concave and convex pattern;

a step of releasing the film-shaped mold from the coating film; and

a step of baking the coating film to which the concave and convex pattern has been transferred.

# Fig. 1

```
┌─────────────────────┐
│      SUBSTRATE      │
│      FORMATION      │ ⌇─ P1
└─────────────────────┘
           │
           ▼
┌─────────────────────┐
│      CLEANING       │ ⌇─ P2
└─────────────────────┘
           │
           ▼
┌─────────────────────┐
│   FIRST ELECTRODE   │
│      FORMATION      │ ⌇─ P3
└─────────────────────┘
           │
           ▼
┌─────────────────────┐
│      ANNEALING      │ ⌇─ P4
└─────────────────────┘
           │
           ▼
┌─────────────────────┐
│     THIN-FILM       │
│     FORMATION       │ ⌇─ P5
└─────────────────────┘
           │
           ▼
┌─────────────────────┐
│       SECOND        │
│     ELECTRODE       │
│     FORMATION       │ ⌇─ P6
└─────────────────────┘
```

# Fig. 2

```
┌─────────────────┐
│  PREPARATION OF │
│   FILM-SHAPED   │ ～ S0
│      MOLD       │
└─────────────────┘
         │
         ▼
┌─────────────────┐
│  PREPARATION OF │ ～ S1
│    SOLUTION     │
└─────────────────┘
         │
         ▼
┌─────────────────┐
│     COATING     │ ～ S2
└─────────────────┘
         │
         ▼
┌─────────────────┐
│     DRYING      │ ～ S3
└─────────────────┘
         │
         ▼
┌─────────────────┐
│    TRANSFER     │ ～ S4
└─────────────────┘
         │
         ▼
┌─────────────────┐
│    RELEASING    │ ～ S5
└─────────────────┘
         │
         ▼
┌─────────────────┐
│   MAIN BAKING   │ ～ S6
└─────────────────┘
```

## Fig. 3

ROLL PROCESSING
APPARATUS 70

CONCAVE-CONVEX
FORMING MATERIAL 84

FILM-SHAPED
MOLD 80a

82

90

78    78    76    78

78    74    ↑↑↑ UV LIGHT

80    72    85    87

SUBSTRATE FILM
TRANSPORTING SYSTEM 86

## Fig. 4

ADVANCING
DIRECTION OF
FILM-SHAPED
MOLD

ROTATING
DIRECTION OF
PRESSING ROLL

23

22

80a

42

42

40

TRANSPORTING ⟶
DIRECTION OF
SUBSTRATE

# Fig. 5

(a)

32

40

(d)

32a

40

(b)

34

40

(e)

32b

40

(c)

44

40

(f)

32b

32b(92)

40

Fig. 6

**Fig. 7**

100

COATING SECTION 120

MOLD TRANSPORTING SECTION 140

30
41
40
34

27
142
29
80a
22a
22
26

21
28

24
29
23

144
146
40

36

PRESSING SECTION 150

RELEASING SECTION 160

SUBSTRATE TRANSPORTING SECTION 130

TRANSPORTING DIRECTION OF SUBSTRATE

## Fig. 8

80a

22

42

40

TRANSPORTING DIRECTION ⟶
OF SUBSTRATE

## Fig. 9

ADVANCING DIRECTION
OF FILM-SHAPED MOLD

121

124

23

80a

22

42

42

40

TRANSPORTING DIRECTION ⟶
OF SUBSTRATE

Fig. 10

TRANSPORTING DIRECTION ⟶
OF SUBSTRATE

Fig. 11

IMAGE
PROCESSING
APPARATUS

# Fig. 12

(a)

(b)

PIXEL POSITION IN X DIRECTION

## INTERNATIONAL SEARCH REPORT

International application No.

PCT/JP2013/051202

### A. CLASSIFICATION OF SUBJECT MATTER
*C03B19/02*(2006.01)i, *G02B5/18*(2006.01)i, *H05B33/02*(2006.01)i, *H05B33/10*(2006.01)i

According to International Patent Classification (IPC) or to both national classification and IPC

### B. FIELDS SEARCHED

Minimum documentation searched (classification system followed by classification symbols)
B29C59/00-59/18, C03B8/00-8/04, C03B19/12-20/00, G02B5/18, H01L21/027, H01L21/033, H01L21/30, H01L21/46, H05B33/00-33/28

Documentation searched other than minimum documentation to the extent that such documents are included in the fields searched
Jitsuyo Shinan Koho        1922-1996    Jitsuyo Shinan Toroku Koho    1996-2013
Kokai Jitsuyo Shinan Koho  1971-2013    Toroku Jitsuyo Shinan Koho    1994-2013

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| X<br>Y | JP 2009-517310 A  (Saint-Gobain Glass France),<br>30 April 2009 (30.04.2009),<br>claims; paragraphs [0071] to [0135], [0148], [0149], [0224] to [0296], [0302]; fig. 1a to 4<br>& US 2009/0162623 A1<br>claims; paragraphs [0083] to [0148], [0165] to [0169], [0263] to [0352], [0358] to [0366]; fig. 1a to 4<br>& EP 1957418 A1          & WO 2007/060353 A1<br>& FR 2893610 A           & FR 2893610 A1<br>& KR 10-2008-0068094 A   & CN 101360689 A | 1-2,7-19,<br>23-32<br>3-6,20-22 |

☒ Further documents are listed in the continuation of Box C.    ☐ See patent family annex.

| | |
|---|---|
| *    Special categories of cited documents:<br>"A"  document defining the general state of the art which is not considered to be of particular relevance<br>"E"  earlier application or patent but published on or after the international filing date<br>"L"  document which may throw doubts on priority claim(s) or which is cited to establish the publication date of another citation or other special reason (as specified)<br>"O"  document referring to an oral disclosure, use, exhibition or other means<br>"P"  document published prior to the international filing date but later than the priority date claimed | "T"  later document published after the international filing date or priority date and not in conflict with the application but cited to understand the principle or theory underlying the invention<br>"X"  document of particular relevance; the claimed invention cannot be considered novel or cannot be considered to involve an inventive step when the document is taken alone<br>"Y"  document of particular relevance; the claimed invention cannot be considered to involve an inventive step when the document is combined with one or more other such documents, such combination being obvious to a person skilled in the art<br>"&"  document member of the same patent family |

| | |
|---|---|
| Date of the actual completion of the international search<br>19 April, 2013 (19.04.13) | Date of mailing of the international search report<br>07 May, 2013 (07.05.13) |
| Name and mailing address of the ISA/<br>Japanese Patent Office | Authorized officer |
| Facsimile No. | Telephone No. |

Form PCT/ISA/210 (second sheet) (July 2009)

**INTERNATIONAL SEARCH REPORT**

| International application No. |
| --- |
| PCT/JP2013/051202 |

C (Continuation).   DOCUMENTS CONSIDERED TO BE RELEVANT

| Category* | Citation of document, with indication, where appropriate, of the relevant passages | Relevant to claim No. |
| --- | --- | --- |
| Y | JP 2010-525968 A  (S.D. Warren Co.),<br>29 July 2010 (29.07.2010),<br>claims; paragraphs [0011], [0029] to [0031],<br>[0034] to [0040], [0052]; fig. 1 to 3<br>& US 2008/0268203 A1<br>claims; paragraphs [0010], [0032] to [0034],<br>[0037] to [0044], [0057], [0058]; fig. 1 to 3<br>& US 2011/0186712 A1     & EP 2146805 A2<br>& WO 2008/137400 A2      & CN 101674896 A<br>& KR 10-2010-0015738 A   & TW 200906585 A<br>& AT 534473 T            & ES 2375589 T | 3-6,20-22 |
| A | JP 2008-6639 A  (Toppan Printing Co., Ltd.),<br>17 January 2008 (17.01.2008),<br>paragraphs [0008], [0009], [0044]<br>(Family: none) | 1-22,31-32 |
| A | JP 2003-257661 A  (Matsushita Electric<br>Industrial Co., Ltd.),<br>12 September 2003 (12.09.2003),<br>claims; paragraphs [0071], [0193] to [0197]<br>& US 2003/0164679 A1<br>paragraphs [0166], [0217] to [0221] | 23-32 |

Form PCT/ISA/210 (continuation of second sheet) (July 2009)

**INTERNATIONAL SEARCH REPORT**

| International application No. |
| --- |
| PCT/JP2013/051202 |

| Box No. II | Observations where certain claims were found unsearchable (Continuation of item 2 of first sheet) |
| --- | --- |

This international search report has not been established in respect of certain claims under Article 17(2)(a) for the following reasons:

1. ☐ Claims Nos.:
   because they relate to subject matter not required to be searched by this Authority, namely:

2. ☐ Claims Nos.:
   because they relate to parts of the international application that do not comply with the prescribed requirements to such an extent that no meaningful international search can be carried out, specifically:

3. ☐ Claims Nos.:
   because they are dependent claims and are not drafted in accordance with the second and third sentences of Rule 6.4(a).

| Box No. III | Observations where unity of invention is lacking (Continuation of item 3 of first sheet) |
| --- | --- |

This International Searching Authority found multiple inventions in this international application, as follows:

```
     The following two inventions (invention groups) are involved in claims.
     (Invention 1) the inventions of claims 1-22
     A method of manufacturing an optical substrate using a continuous film-like
mold.
     (Invention 2) the inventions of claims 23-32
     A method of manufacturing a device including an optical substrate.
```

1. ☐ As all required additional search fees were timely paid by the applicant, this international search report covers all searchable claims.

2. ☒ As all searchable claims could be searched without effort justifying additional fees, this Authority did not invite payment of additional fees.

3. ☐ As only some of the required additional search fees were timely paid by the applicant, this international search report covers only those claims for which fees were paid, specifically claims Nos.:

4. ☐ No required additional search fees were timely paid by the applicant. Consequently, this international search report is restricted to the invention first mentioned in the claims; it is covered by claims Nos.:

**Remark on Protest**
☐ The additional search fees were accompanied by the applicant's protest and, where applicable, the payment of a protest fee.

☐ The additional search fees were accompanied by the applicant's protest but the applicable protest fee was not paid within the time limit specified in the invitation.

☐ No protest accompanied the payment of additional search fees.

Form PCT/ISA/210 (continuation of first sheet (2)) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2006236748 A
- WO 2011007878A1 A
- JP 2011006487 A